# EUROPEAN PATENT APPLICATION

(11) **EP 4 836 618 A1**
(43) Date of publication of application: **04.11.2026**
(21) Application number: 26175049.1
(22) Date of filing: 28.04.2026
(51) Int. Cl.: H05K 7/20, H05K 7/14

(54) **VEHICLE-MOUNTED POWER SUPPLY APPARATUS, POWERTRAIN, AND ELECTRIC VEHICLE**

(30) Priority: 29.04.2025 CN 202520847310 U
(71) Applicant: Huawei Technologies Co., Ltd., Shenzhen, Guangdong 518129 (CN)
(72) Inventor: BAI, Lifei, Shenzhen, 518129 (CN); XU, Yankun, Shenzhen, 518129 (CN); ZHANG, Weilong, Shenzhen, 518129 (CN)
(74) Representative: Isarpatent

(57) **Abstract**

A vehicle-mounted power supply apparatus, a powertrain, and an electric vehicle relate to the field of electric vehicle technologies. The vehicle-mounted power supply apparatus includes a liquid cooling radiator and a power module, and the power module includes a packaging housing and a plurality of electrical connectors protruding from a surface of the packaging housing. The vehicle-mounted power supply apparatus includes a vertical insulation plate, and the vertical insulation plate is located between two electrical connectors on a same side of the packaging housing. In this application, the vehicle-mounted power supply apparatus is provided with the vertical insulation plate, and the vertical insulation plate is mounted between two adjacent electrical connectors, so that an electrical clearance and a creepage distance between the two adjacent electrical connectors can be increased, to avoid a problem such as a short circuit or a failure of the power module, so as to improve overall performance of a motor control unit and the electric vehicle. In addition, the vertical insulation plate fits with a main body of the power module, so that assembly is simple, and costs are low.

## Description

### TECHNICAL FIELD

This application relates to the field of electric vehicle technologies, and in particular, to a vehicle-mounted power supply apparatus, a powertrain, and an electric vehicle.

### BACKGROUND

An electric vehicle uses a powertrain as a power source, and the powertrain can convert electric energy in a battery into mechanical energy to drive the vehicle to travel. The powertrain drives, by using a motor control unit, a motor to operate. When the motor control unit operates, an internal power module and the like generate heat, and internal pressure increases. When the motor control unit stops operating, internal air temperature decreases, and the internal power module of the control unit cools to cause condensation on a surface to generate condensate water. This is likely to cause a fault such as a short circuit, endangering safe operation of the motor control unit.

### SUMMARY

This application provides a vehicle-mounted power supply apparatus, a powertrain, and an electric vehicle. According to a first aspect, a vehicle-mounted power supply apparatus is configured to supply power to a load of an electric vehicle, the vehicle-mounted power supply apparatus includes a liquid cooling radiator and a power module, the liquid cooling radiator and the power module are stacked in a thickness direction of the liquid cooling radiator, the power module includes a packaging housing and a plurality of electrical connectors protruding from a surface of the packaging housing, and at least two of the plurality of electrical connectors are arranged on a same side of the packaging housing in a direction perpendicular to a thickness of the liquid cooling radiator. The vehicle-mounted power supply apparatus includes a vertical insulation plate extending in the thickness direction of the liquid cooling radiator, and the vertical insulation plate is located between two electrical connectors on a same side of the packaging housing.

In this application, the vehicle-mounted power supply apparatus is provided with the vertical insulation plate, and the vertical insulation plate is mounted between two adjacent electrical connectors, so that an electrical clearance and a creepage distance between the two adjacent electrical connectors can be increased, to avoid a problem such as a short circuit or a failure of the power module, so as to improve overall performance of a motor control unit and the electric vehicle. In addition, the vertical insulation plate fits with a main body of the power module, so that assembly is simple, and costs are low.

In a possible implementation, the power module further includes a horizontal insulation plate, the horizontal insulation plate extends in a thickness direction of the vertical insulation plate, and the horizontal insulation plate protrudes from a surface of the packaging housing and is connected to the vertical insulation plate.

In this embodiment of this application, the horizontal insulation plate is disposed on the vertical insulation plate, and the horizontal insulation plate can be attached to the packaging housing. This avoids creepage between the two adjacent electrical connectors along a surface of the packaging housing, and increases the creepage distance between the two adjacent electrical connectors, to avoid a short circuit between the two adjacent electrical connectors, so as to avoid a short circuit of the power module.

In a possible implementation, in an arrangement direction of the at least two electrical connectors, a sum of lengths of two adjacent electrical connectors and a length of a gap between the two adjacent electrical connectors is less than or equal to a length of the horizontal insulation plate, and the length of the horizontal insulation plate is less than a length of the packaging housing.

In this embodiment of this application, the horizontal insulation plate can fully protect the packaging housing and the electrical connector, to avoid creepage between the two adjacent electrical connectors along the surface of the packaging housing, and increase the creepage distance between the two adjacent electrical connectors, so as to avoid a short circuit of the power module. In addition, the length of the horizontal insulation plate is not beyond the length of the packaging housing, to avoid interference in mounting of another electrical component.

In a possible implementation, the power module further includes another horizontal insulation plate, the another horizontal insulation plate extends in the thickness direction of the vertical insulation plate, and the another horizontal insulation plate is configured to: be located on two sides of the packaging housing with the horizontal insulation plate in the thickness direction of the liquid cooling radiator, protrude from another surface of the packaging housing, and connect to the vertical insulation plate.

In this embodiment of this application, the another horizontal insulation plate is disposed on the vertical insulation plate, and the another horizontal insulation plate and the horizontal insulation plate are jointly attached to the packaging housing, and are configured to jointly clamp the vertical insulation plate, to prevent the vertical insulation plate from detaching during working of the vehicle-mounted power supply apparatus, so as to ensure stability of the vertical insulation plate on the vehicle-mounted power supply apparatus during working.

In a possible implementation, the power module includes a connection plate, the vertical insulation plate is configured to be fastened to the connection plate, and the connection plate is configured to connect to the horizontal insulation plate and the another horizontal insulation plate in the thickness direction of the liquid cooling radiator.

In this embodiment of this application, the connection plate and the vertical insulation plate are fastened together on the vehicle-mounted power supply apparatus, and the connection plate, the horizontal insulation plate, and the another horizontal insulation plate jointly clamp the packaging housing. This can enhance stability of connection between the connection plate and a plurality of electrical connectors, and increase the creepage distance between the two adjacent electrical connectors along the surface of the packaging housing, to avoid a short circuit of the power module.

In a possible implementation, the connection plate includes a through hole, and the through hole is configured to: run through the connection plate in an arrangement direction of the electrical connector and the packaging housing, and accommodate the electrical connector.

In this embodiment of this application, the through hole is provided on the connection plate, so that the electrical connector can pass through the through hole. In a possible implementation, the electrical connector abuts against an inner wall of the through hole, to enhance stability of connection between the electrical connector and the through hole, and prevent the electrical connector from sliding relative to an insulation member.

In a possible implementation, the power module includes another connection plate, the vertical insulation plate is configured to be fastened to the another connection plate, the another connection plate is configured to be located on a same side of the electrical connector as the liquid cooling radiator in the thickness direction of the liquid cooling radiator, the another connection plate includes another through hole, and the another through hole is configured to run through the another connection plate in the thickness direction of the liquid cooling radiator.

In this embodiment of this application, the vehicle-mounted power supply apparatus is provided with the another connection plate, to bear the electrical connector and separate the electrical connector from another electrical component, so as to avoid interference of the another electrical component to the electrical connector, and increase an insulation distance between the another electrical component and the electrical connector.

In a possible implementation, in an arrangement direction of the at least two electrical connectors, a length of the another connection plate is greater than or equal to a length of at least one electrical connector, and a length of the another connection plate on a side of the vertical insulation plate is less than or equal to a length of the packaging housing on the same side of the vertical insulation plate.

In this embodiment of this application, the length of the another connection plate is greater than or equal to a length of an electrical connector, to ensure that the another connection plate can fully bear the electrical connector, to avoid interference between the electrical component and another electrical component. The length of the another connection plate is not beyond a length of the packaging housing, to avoid interference in mounting of another electrical component.

In a possible implementation, there are at least two other connection plates, and the at least two connection plates are located on two sides of the vertical insulation plate in the arrangement direction of the at least two electrical connectors.

In this embodiment of this application, each of the other connection plates can bear one electrical connector, and the vertical insulation plate can separate the other connection plates, to protect each electrical connector.

In a possible implementation, the vehicle-mounted power supply apparatus includes a fastened plate, the fastened plate, the liquid cooling radiator, and the power module are sequentially arranged in the thickness direction of the liquid cooling radiator, the fastened plate includes a third through hole, an outer wall surface on a side that is of the another connection plate and that faces the fastened plate includes a third protrusion, and the third protrusion is configured to pass through the third through hole in the thickness direction of the liquid cooling radiator.

In this embodiment of this application, the vehicle-mounted power supply apparatus is provided with the fastened plate, and the fastened plate is configured to be fastened to the liquid cooling radiator, to enhance stability of the liquid cooling radiator. The third through hole is provided on the fastened plate, and the third protrusion is disposed on the another connection plate, so that the third protrusion passes through the third through hole, to prevent the vertical insulation plate from moving in a direction perpendicular to the thickness direction of the liquid cooling radiator, so as to ensure reliability and stability of the vertical insulation plate.

In a possible implementation, at least three of the plurality of electrical connectors are arranged on a same side of the packaging housing, and at least one vertical insulation plate is included between any two adjacent electrical connectors in an arrangement direction of the at least three electrical connectors.

In this embodiment of this application, a vertical insulation plate is disposed between two adjacent electrical connectors, so that an electrical clearance and a creepage distance between the two adjacent electrical connectors can be increased, to ensure safety between the two adjacent electrical connectors, so as to avoid a short circuit of the power module.

In a possible implementation, a side edge on a side of the packaging housing includes a recess, the recess is configured to accommodate a side edge on a side of the vertical insulation plate, in the arrangement direction of the at least two electrical connectors, a length of the recess is equal to a length of the vertical insulation plate, and in the arrangement direction of the electrical connector and the packaging housing, the side edge on the side of the vertical insulation plate is configured to be attached to a bottom wall of the recess.

In this embodiment of this application, the recess is provided on the side edge on the side of the packaging housing, and the vertical insulation plate is in an interference fit with the recess, to avoid occurrence of a gap, so as to avoid creepage between the two adjacent electrical connectors caused by flowing of condensate water or other impurities into the gap, so that the power module does not short-circuit, fail, or the like.

In a possible implementation, the vehicle-mounted power supply apparatus includes a water absorption layer, the liquid cooling radiator is configured to be fastened to the water absorption layer, and the water absorption layer, the liquid cooling radiator, and the power module are sequentially arranged in the thickness direction of the liquid cooling radiator.

In this embodiment of this application, the vehicle-mounted power supply apparatus is provided with the water absorption layer, and the water absorption layer is attached to a side that is of the liquid cooling radiator and that faces away from the power module, to absorb condensate water generated by the liquid cooling radiator in a process of cooling the power module, so as to prevent the condensate water from flowing to the power module and causing a short circuit of the power module, and ensure safety of using the power module.

According to a second aspect, this application provides a powertrain, including the vehicle-mounted power supply apparatus according to any one of the foregoing. The vehicle-mounted power supply apparatus is configured to connect to a motor. In this application, the vehicle-mounted power supply apparatus is integrated into a motor control unit container of the powertrain, so that a structure design and production are simpler, and a degree of integration of the powertrain is increased. In addition, the vehicle-mounted power supply apparatus is provided with the vertical insulation plate, and the vertical insulation plate is mounted between the two adjacent electrical connectors, so that the electrical clearance and the creepage distance between the two adjacent electrical connectors can be increased, to avoid a problem such as a short circuit or a failure of the power module, so as to improve overall performance of the powertrain. In addition, the vertical insulation plate fits with the main body of the power module, so that assembly is simple, and costs are low.

According to a third aspect, this application provides an electric vehicle, including a wheel and the foregoing powertrain. The powertrain is configured to drive the wheel. In this application, the vehicle-mounted power supply apparatus of the powertrain is provided with the vertical insulation plate, and the vertical insulation plate is mounted between the two adjacent electrical connectors, so that the electrical clearance and the creepage distance between the two adjacent electrical connectors can be increased, to avoid a problem such as a short circuit or a failure of the power module, so as to improve overall performance of a motor control unit and the electric vehicle.

### BRIEF DESCRIPTION OF DRAWINGS

FIG. 1 is a diagram of an electric vehicle according to an embodiment of this application;
FIG. 2 is a diagram of a powertrain according to an embodiment of this application;
FIG. 3 is an assembly diagram of a powertrain according to an embodiment of this application;
FIG. 4 is a diagram of the inside of a motor control unit container of a powertrain according to an embodiment of this application;
FIG. 5 is an exploded view of a vehicle-mounted power supply apparatus according to an embodiment of this application;
FIG. 6 is another diagram of a vehicle-mounted power supply apparatus according to an embodiment of this application;
FIG. 7 is a diagram of a relationship between a power module and a vertical insulation plate according to an embodiment of this application;
FIG. 8 is another diagram of a relationship between a power module and a vertical insulation plate according to an embodiment of this application;
FIG. 9 is another diagram of a relationship between a power module and a vertical insulation plate according to an embodiment of this application;
FIG. 10 is another diagram of a relationship between a power module and a vertical insulation plate according to an embodiment of this application;
FIG. 11 is another diagram of a relationship between a power module and a vertical insulation plate according to an embodiment of this application;
FIG. 12 is another diagram of a relationship between a power module and a vertical insulation plate according to an embodiment of this application;
FIG. 13 is another diagram of a relationship between a power module and a vertical insulation plate according to an embodiment of this application;
FIG. 14 is a diagram of a relationship between a fastened plate, a liquid cooling radiator, and a power module according to an embodiment of this application;
FIG. 15 is another diagram of a relationship between a power module and a vertical insulation plate according to an embodiment of this application;
FIG. 16 is a diagram of a vertical insulation plate according to an embodiment of this application;
FIG. 17 is another diagram of a vertical insulation plate according to an embodiment of this application;
FIG. 18 is another diagram of a vehicle-mounted power supply apparatus according to an embodiment of this application; and
FIG. 19 is another diagram of a vehicle-mounted power supply apparatus according to an embodiment of this application.

### DESCRIPTION OF EMBODIMENTS

The following describes embodiments of this application with reference to accompanying drawings in embodiments of this application.

It should be clear that the described embodiments are merely some but not all of embodiments of this application. All other embodiments obtained by a person of ordinary skill in the art based on embodiments of this application without creative efforts shall fall within the protection scope of this application.

An electric vehicle uses a powertrain as a power source, and the powertrain can convert electric energy in a battery into mechanical energy to drive the vehicle to travel. The powertrain drives, by using a motor control unit, a motor to operate. When the motor control unit works, an internal power module and the like generate heat, and internal pressure increases. When the motor control unit stops working, internal air temperature decreases, and the internal power module of the control unit cools to generate condensate water on a surface. This is likely to cause a fault such as a short circuit, endangering safe operation of the motor control unit.

To resolve the foregoing problem, this application provides a vehicle-mounted power supply apparatus used in a powertrain, and the powertrain is used in an electric vehicle, to improve overall performance of the electric vehicle.

This application provides a vehicle-mounted power supply apparatus used in an electric vehicle. The vehicle-mounted power supply apparatus is configured to supply power to a load of the electric vehicle, the vehicle-mounted power supply apparatus includes a liquid cooling radiator and a power module, the liquid cooling radiator and the power module are stacked in a thickness direction of the liquid cooling radiator, the power module includes a packaging housing and a plurality of electrical connectors protruding from a surface of the packaging housing, and at least two of the plurality of electrical connectors are arranged on a same side of the packaging housing in a direction perpendicular to a thickness of the liquid cooling radiator. The vehicle-mounted power supply apparatus includes a vertical insulation plate extending in the thickness direction of the liquid cooling radiator, and the vertical insulation plate is located between two electrical connectors on a same side of the packaging housing.

In this application, the vehicle-mounted power supply apparatus is provided with the vertical insulation plate, and the vertical insulation plate is mounted between two adjacent electrical connectors, so that an electrical clearance and a creepage distance between the two adjacent electrical connectors can be increased, to avoid a problem such as a short circuit or a failure of the power module, so as to improve overall performance of a motor control unit and the electric vehicle. In addition, the vertical insulation plate fits with a main body of the power module, so that assembly is simple, and costs are low.

An embodiment of this application provides an electric vehicle. The electric vehicle 1 includes a two-wheeled, three-wheeled, or four-wheeled vehicle. In this embodiment of this application, the electric vehicle 1 includes a battery electric vehicle (BEV, Battery Electric Vehicle), a hybrid electric vehicle (HEV, Hybrid Electric Vehicle), and a range extended electric vehicle (REEV, Range Extended Electric Vehicle).

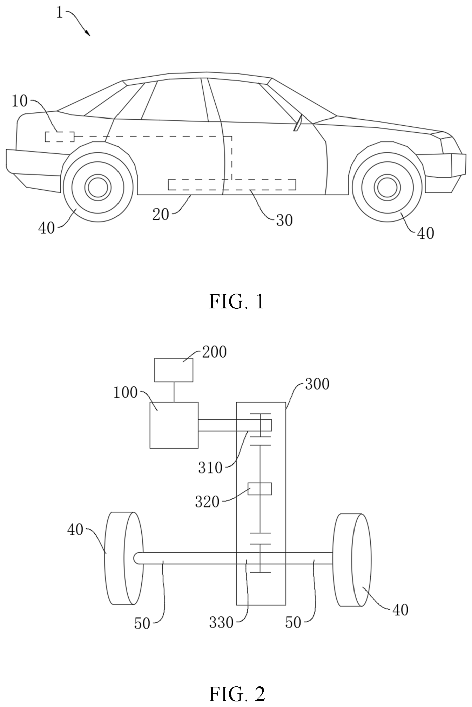

FIG. 1 is a diagram of an electric vehicle according to an embodiment of this application. FIG. 2 is a diagram of a powertrain according to an embodiment of this application. The electric vehicle 1 includes a powertrain 10, a frame 20, and a power battery 30. The frame 20 is configured to fasten the power battery 30 and the powertrain 10. As a structural framework of the electric vehicle 1, the frame 20 is configured to: support and fasten the powertrain 10 and the power battery 30, and bear a load inside a vehicle system and a load of an external environment. A drive motor 100 of the powertrain 10 is configured to drive two front wheels 40 or two rear wheels 40 of the electric vehicle 1.

In an embodiment, the electric vehicle 1 includes one frame 20. The frame 20 is configured to fasten the power battery 30 and the powertrain 10. As a structural framework of the electric vehicle 1, the frame 20 is configured to: support and fasten the powertrain 10 and the power battery 30, and bear a load inside a vehicle system and a load of an external environment.

An embodiment of this application provides a powertrain. Refer to FIG. 1 and FIG. 2. The powertrain 10 includes a drive motor 100, a vehicle-mounted power supply apparatus 200, and a reducer 300. In an embodiment, the reducer 300 includes a single-speed reducer, a two-speed reducer, or a transmission. In an embodiment, the reducer 300 includes an input shaft 310, an intermediate shaft 320, and an output shaft 330. As shown in FIG. 2, the reducer 300 includes the input shaft 310, the intermediate shaft 320, and the output shaft 330. The input shaft 310 is configured to be in transmission connection to the drive motor 100 and the intermediate shaft 320, the intermediate shaft 320 is configured to be in transmission connection to the output shaft 330, and the output shaft 330 is configured to be in transmission connection to a wheel 40. In an embodiment, the reducer 300 is in transmission connection to two wheels 40 through two half shafts 50 respectively. In an embodiment, the vehicle-mounted power supply apparatus 200 is configured to supply power to a load of the electric vehicle. The load of the electric vehicle includes the power battery, a direct current-direct current module, an air conditioner of the electric vehicle, or the like. In an embodiment, the vehicle-mounted power supply apparatus 200 is configured to: receive an alternating current, and convert the alternating current into a direct current to charge the power battery 30. In an embodiment, the vehicle-mounted power supply apparatus 200 is configured to: receive a high-voltage direct current, and supply the direct current to the power battery 30 for charging. In an embodiment, the vehicle-mounted power supply apparatus includes a vehicle-mounted charger, a motor control unit, a direct current-direct current converter, or another vehicle-mounted power supply apparatus.

In an embodiment, the vehicle-mounted power supply apparatus 200 is configured to: receive a direct current of the power battery 30, convert the direct current into an alternating current, and transmit the alternating current to the drive motor 100. The drive motor 100 converts electric energy into mechanical energy. The drive motor 100 is configured to be in transmission connection to the reducer 300. The drive motor 100 drives, through the reducer 300, the wheel 40 of the electric vehicle 1 to rotate. In an embodiment, the vehicle-mounted charger converts an alternating current of a power grid into a direct current, and transmits the direct current to the power battery 30 for charging. In an embodiment, the vehicle-mounted charger includes a direct current converter module. The direct current converter module converts a high-voltage direct current into a low-voltage direct current, to supply power to a low-voltage electrical system such as a light, a dashboard, or the air conditioner in the electric vehicle 1.

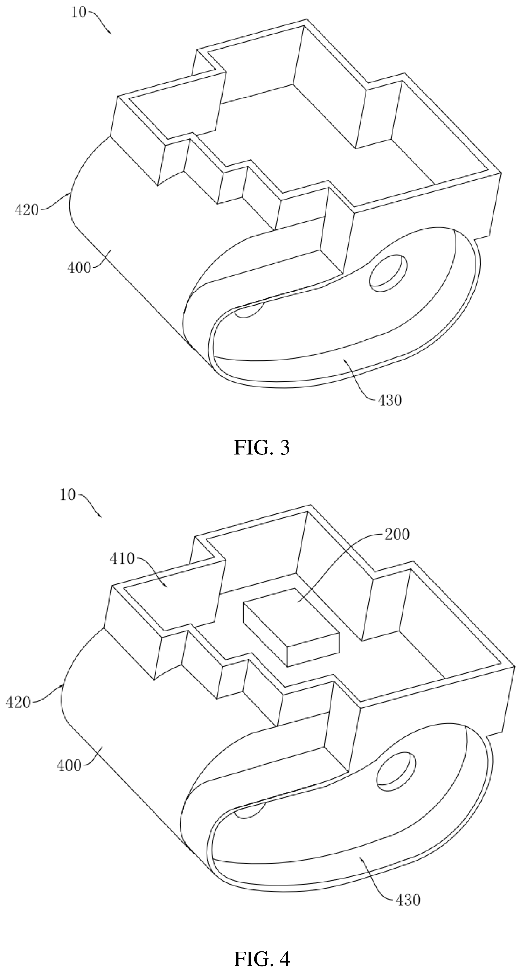

FIG. 3 is an assembly diagram of a powertrain according to an embodiment of this application. FIG. 4 is a diagram of the inside of a motor control unit container of a powertrain according to an embodiment of this application.

In an embodiment, with reference to FIG. 3 and FIG. 4, a housing 400 of the powertrain 10 includes a motor control unit container 410, a motor container 420, and a reducer container 430. This application provides a vehicle-mounted power supply apparatus. In embodiments of this application, a motor control unit is used as an example of the vehicle-mounted power supply apparatus 200. The motor control unit is merely an embodiment for description. During actual application, the vehicle-mounted power supply apparatus is not limited to the motor control unit. Other similar structures, for example, other vehicle-mounted power supply apparatuses including a liquid cooling radiator and a power module and having a vertical insulation plate, fall within the protection scope of this application. The vehicle-mounted power supply apparatus 200 is a part of the powertrain 10, and is integrated into the housing 400 of the powertrain 10. The motor control unit container 410 of the powertrain is configured to accommodate a plurality of electrical components of the motor control unit, including a component such as a capacitor or an inductor or a combination of components. The electrical component is configured to perform power supply conversion in the motor control unit. The motor container 420 and the reducer container 430 of the powertrain are distributed on two axial sides of the housing 400 of the powertrain. The motor container 420 is configured to accommodate the drive motor of the powertrain 10. An axis of the drive motor is parallel to an axis of the motor container 420. An orientation of an opening of the motor container 420 is opposite to an orientation of an opening of the reducer container 430 in an axial direction of the housing 400. The housing 400 of the powertrain includes a motor end cover and a reducer end cover, the motor end cover is configured to enclose the motor container 420, and the reducer end cover is configured to enclose the reducer container 430. The motor control unit container 410 is located on a radial side of the motor container 420, and an inner wall of the motor control unit container 410 may be a part of an outer wall surface of the motor container 420, to form an accommodation cavity with large capacity, so as to meet a mounting requirement of the vehicle-mounted power supply apparatus 200.

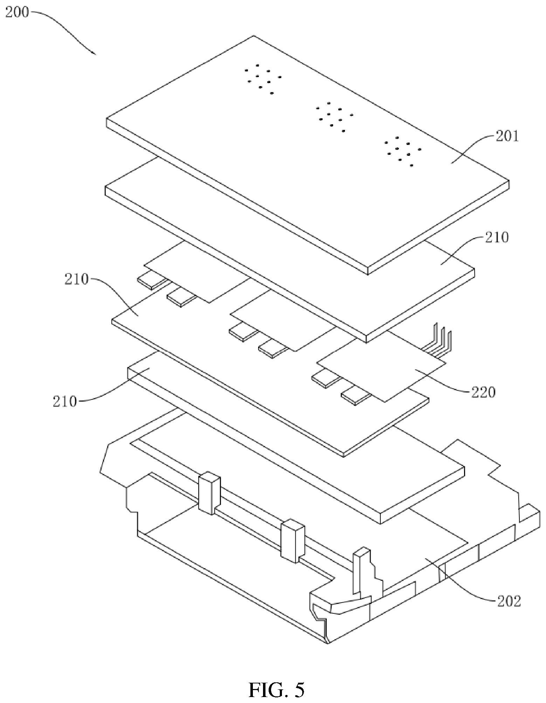

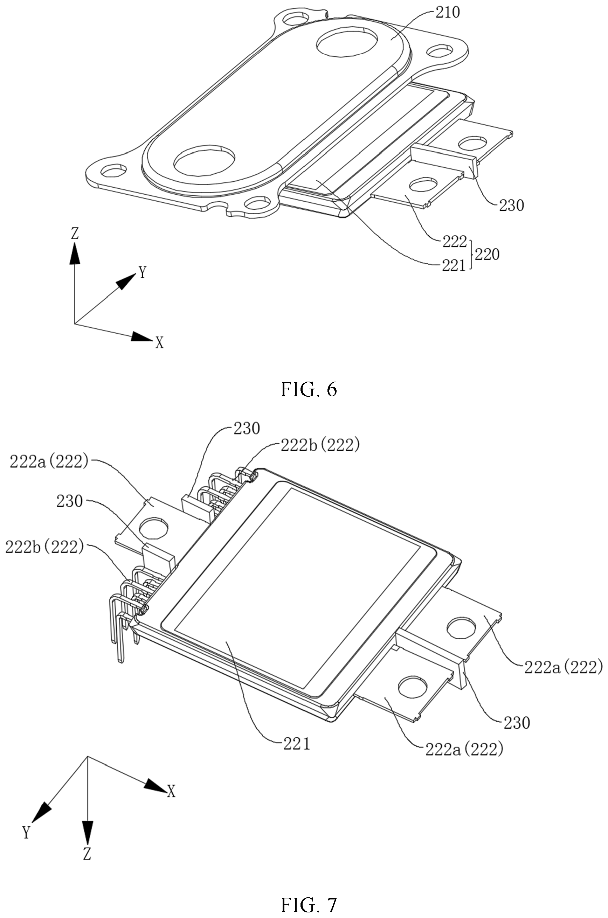

FIG. 5 is an exploded view of a vehicle-mounted power supply apparatus according to an embodiment of this application. FIG. 6 is another diagram of a vehicle-mounted power supply apparatus according to an embodiment of this application. FIG. 7 is a diagram of a relationship between a power module and a vertical insulation plate according to an embodiment of this application.

In an embodiment, with reference to FIG. 5, the vehicle-mounted power supply apparatus 200 includes a circuit board 201, a liquid cooling radiator 210, a power module 220, a capacitor, and a housing 202 of the vehicle-mounted power supply apparatus. The circuit board 201, the liquid cooling radiator 210, the power module 220, and the capacitor are jointly integrated into the housing 202 of the vehicle-mounted power supply apparatus, to help optimize utilization of space of the vehicle-mounted power supply apparatus 200. The circuit board 201, the liquid cooling radiator 210, and the power module 220 are stacked in a thickness direction of the liquid cooling radiator 210, to achieve an efficient heat dissipation path. The circuit board 201 is electrically connected to the power module 220, and is configured to control operation of the power module 220. The power module 220 is configured to implement conversion between a direct current and an alternating current, and the power module 220 generates heat during operation. The liquid cooling radiator 210 is configured to dissipate heat from the circuit board 201 and the power module 220, to ensure normal working of the circuit board 201 and the power module 220. There may be one, two, or three liquid cooling radiators 210 or the like. Disposing a plurality of liquid cooling radiators 210 helps improve effect of dissipating heat from the power module 220 by the liquid cooling radiator 210. In an embodiment, the liquid cooling radiator 210 may be a single-layer heat dissipation plate structure, and the liquid cooling radiator 210 and the power module 220 are stacked in the thickness direction of the liquid cooling radiator 210, to dissipate heat from the power module 220. In an embodiment, the liquid cooling radiator 210 may be a double-layer heat dissipation plate structure, and the double-layer heat dissipation plate is symmetrically disposed on two sides of the power module 220. This helps improve effect of dissipating heat from the power module 220 by the heat dissipation plate, and temperature is even.

In an embodiment, with reference to FIG. 6 and FIG. 7, the vehicle-mounted power supply apparatus 200 includes the liquid cooling radiator 210 and the power module 220. The liquid cooling radiator 210 and the power module 220 are configured to be stacked in the thickness direction of the liquid cooling radiator 210, to achieve an efficient heat dissipation path. The liquid cooling radiator 210 is a single-layer heat dissipation plate structure. The thickness direction of the liquid cooling radiator 210 and a direction perpendicular to an axial direction of the motor control unit container 410 are a Z direction. The liquid cooling radiator 210 is located on a side of the power module 220 in a Z positive direction. In an embodiment, the power module 220 includes an insulated gate bipolar transistor (Insulated Gate Bipolar Transistor, IGBT) module, a silicon carbide power module, or the like, and is applicable to a high-voltage and high-power scenario of a new energy vehicle or the like.

In embodiments of this application, an IGBT module is used as an example of the power module. The IGBT module is merely an embodiment for description. During actual application, the power module is not limited to the IGBT module. Other similar power modules fall within the protection scope of this application. In an embodiment, the power module 220 includes a packaging housing 221 and at least two electrical connectors 222. The packaging housing 221 is configured to protect an internal structure of the power module 220, and has insulation and heat conduction functions. The at least two electrical connectors 222 are located on a same side of the packaging housing 221 in a direction perpendicular to a thickness of the liquid cooling radiator 210. A direction in which the packaging housing 221 faces the electrical connectors 222 is an X positive direction. The at least two electrical connectors 222 are located at two ends of an X direction. An arrangement direction of the at least two electrical connectors 222 is a Y direction. In an embodiment, a side of the packaging housing 221 in the X direction is an alternating-current power terminal side, configured to convert an alternating current into a direct current for output, and another side of the packaging housing 221 in the X direction is a direct-current power terminal side, configured to convert a direct current into a direct current for output. In an embodiment, the electrical connector 222 includes a copper bar connector, a pin, or the like, and the electrical connector 222 is configured to electrically connect to the packaging housing 221.

In an embodiment, with reference to FIG. 7, the vehicle-mounted power supply apparatus 200 includes a vertical insulation plate 230. The vertical insulation plate 230 is located between two adjacent electrical connectors 222 in the arrangement direction of the at least two electrical connectors 222, and the vertical insulation plate 230 is configured to be attached to the packaging housing in an arrangement direction of the electrical connector 222 and the packaging housing 221.

In an embodiment, with reference to FIG. 7, a shape of the vertical insulation plate 230 may be a rectangle, and the vertical insulation plate 230 extends in the Z direction. In the X direction, a side wall that is of the vertical insulation plate 230 and that faces the packaging housing 221 is connected to a side wall that is of the packaging housing 221 and that corresponds to the side wall of the vertical insulation plate 230, to implement attachment to the packaging housing 221. In this way, the vertical insulation plate 230 is stably connected to the packaging housing 221, to prevent the vertical insulation plate 230 from sliding or detaching during working. In an embodiment, in this application, the vehicle-mounted power supply apparatus is provided with the vertical insulation plate, and the vertical insulation plate is mounted between the two adjacent electrical connectors, so that an electrical clearance and a creepage distance between the two adjacent electrical connectors can be increased, to avoid a problem such as a short circuit or a failure of the power module, so as to improve overall performance of the motor control unit and the electric vehicle. In addition, the vertical insulation plate fits with a main body of the power module, so that assembly is simple, and costs are low.

In an embodiment, the liquid cooling radiator 210 includes a water path plate, the liquid cooling radiator 210 includes a water path, the water path in the liquid cooling radiator 210 is used for a coolant to flow, and the coolant in the water path is configured to dissipate heat from the power module 220. In an embodiment, the liquid cooling radiator 210 may be fastened to the power module 220 by using a fastener, a screw, or the like, so that the liquid cooling radiator 210 is attached to the power module 220, to improve efficiency of dissipating heat from the power module 220 by the liquid cooling radiator 210.

In an embodiment, in the X direction, the side wall that is of the vertical insulation plate 230 and that faces the packaging housing 221 is connected to the side wall that is of the packaging housing 221 and that corresponds to the side wall of the vertical insulation plate 230; in the Y direction, a side wall of the vertical insulation plate 230 is connected to a side wall of one electrical connector 222; and in the Y direction, another side wall disposed opposite to the side wall of the vertical insulation plate 230 is connected to a side wall of the other electrical connector 222 adjacent to the electrical connector. In this way, the vertical insulation plate 230 is located between the two adjacent electrical connectors 222, to increase the electrical clearance between the two adjacent electrical connectors 222, and the vertical insulation plate 230 is attached to the packaging housing 221 and the electrical connectors 222, so that the vertical insulation plate 230 is stably connected to the packaging housing 221 and the electrical connectors 222, to prevent the vertical insulation plate 230 from sliding or detaching during working. In an embodiment, in the Z direction, a length of the vertical insulation plate 230 is greater than a length of the packaging housing 221, and in the Z positive direction, a side of the vertical insulation plate 230 and the liquid cooling radiator 210 are located on a same side of the electrical connector 222, so that the vertical insulation plate 230 achieves better protection effect, to prevent the two adjacent electrical connectors 222 from bypassing the vertical insulation plate 230 to cause creepage. In an embodiment, in the Z direction, the length of the vertical insulation plate 230 is equal to the length of the packaging housing 221; in the Z positive direction, the side of the vertical insulation plate 230 and the liquid cooling radiator 210 are located on the same side of the electrical connector 222; and in the X direction, a side of the vertical insulation plate 230 and a bottom wall of the packaging housing 221 are located on a same horizontal plane. In an embodiment, in the Z direction, the length of the vertical insulation plate 230 is less than the length of the packaging housing 221, and in the Z positive direction, the side of the vertical insulation plate 230 and the liquid cooling radiator 210 are located on the same side of the electrical connector 222. In an embodiment, the vertical insulation plate 230 has a specific width in the Y direction, and the vertical insulation plate 230 is located between the two adjacent electrical connectors 222, and is configured to increase an insulation distance between the two adjacent electrical connectors 222.

In an embodiment, the vertical insulation plate 230 and the packaging housing 221 are independent structures that can be separated from each other, and the vertical insulation plate 230 may be fastened to the packaging housing 221 by using an adhesive, a fastener, a screw, or the like, so that the vertical insulation plate 230 is attached to the packaging housing 221.

In an embodiment, the vertical insulation plate 230 may be fastened to the electrical connectors 222 by using an adhesive, a fastener, a screw, or the like, so that the vertical insulation plate 230 is attached to the two electrical connectors 222.

In an embodiment, a material of the vertical insulation plate 230 may be an insulating material such as silicone rubber or silicone. The vertical insulation plate 230 is made of a soft insulating material, to facilitate mounting or replacement of the vertical insulation plate 230, so that detachment is convenient, and costs are low.

In an embodiment, the housing 400 of the powertrain 10 and the housing of the vehicle-mounted power supply apparatus 200 are an integrated structure. In other words, the housing of the vehicle-mounted power supply apparatus 200 is the housing 400 of the powertrain 10. The housing 400 includes the motor control unit container 410. The motor control unit container 410 of the vehicle-mounted power supply apparatus is configured to accommodate a plurality of electrical components of the vehicle-mounted power supply apparatus 200. The electrical components refer to components such as a capacitor and an inductor or a combination of components, and are located in the vehicle-mounted power supply apparatus 200 for power supply conversion.

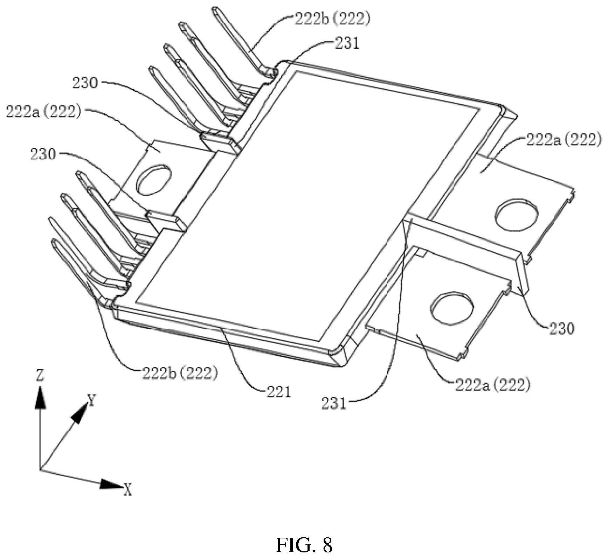

FIG. 8 is another diagram of a relationship between a power module and a vertical insulation plate according to an embodiment of this application.

In an embodiment, with reference to FIG. 8, the power module 220 further includes a horizontal insulation plate 231, the horizontal insulation plate 231 extends in a thickness direction of the vertical insulation plate 230, and the horizontal insulation plate 231 protrudes from a surface of the packaging housing 221 and is connected to the vertical insulation plate 230.

In this embodiment of this application, a side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The power module 220 includes a horizontal insulation plate 231 extending in an X reverse direction. In the Y direction, the horizontal insulation plate 231 separately extends in directions of the two electrical connectors 222. In the Z positive direction, the horizontal insulation plate 231 and the liquid cooling radiator 210 are located on a same side of the packaging housing 221. The horizontal insulation plate 231 is attached to the packaging housing 221. This avoids creepage between the two adjacent copper bar connectors 222a along a surface of the packaging housing 221, and increases a creepage distance between the two adjacent copper bar connectors 222a, to avoid a short circuit between the two adjacent copper bar connectors 222a, so as to avoid a short circuit of the power module 220.

In an embodiment, the vertical insulation plate 230 and the horizontal insulation plate 231 are independent structures that can be separated from each other, and the vertical insulation plate 230 may be fastened to the horizontal insulation plate 231 by using an adhesive, a fastener, a screw, or the like, so that the vertical insulation plate 230 is attached to the horizontal insulation plate 231. In an embodiment, the vertical insulation plate 230 and the horizontal insulation plate 231 are an integrated structure, and the horizontal insulation plate 231 is synchronously formed during integrated injection molding.

In an embodiment, the horizontal insulation plate 231 and the packaging housing 221 are independent structures that can be separated from each other, and the horizontal insulation plate 231 may be fastened to the packaging housing 221 by using an adhesive, a fastener, a screw, or the like, so that the horizontal insulation plate 231 is attached to the packaging housing 221.

In this embodiment of this application, with reference to FIG. 8, a side of the power module in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b. There are two vertical insulation plates 230, and there are two horizontal insulation plates 231. One vertical insulation plate 230 is disposed between two adjacent electrical connectors 222. The power module 220 includes the horizontal insulation plate 231 extending in the X positive direction. In the Z positive direction, the horizontal insulation plate 231 and the liquid cooling radiator 210 are located on a same side of the packaging housing 221. The horizontal insulation plate 231 is attached to the packaging housing 221. This avoids creepage between the two adjacent electrical connectors 222 along a surface of the packaging housing 221, and increases a creepage distance between the two adjacent electrical connectors 222, to avoid a short circuit between the two adjacent electrical connectors 222, so as to avoid a short circuit of the power module 220.

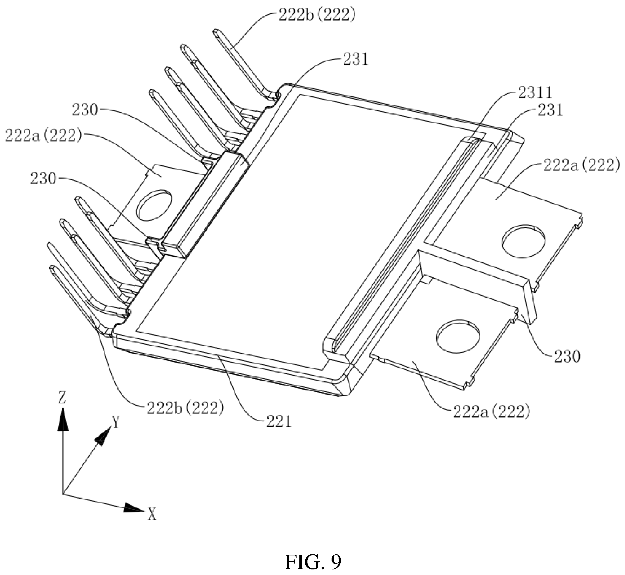

FIG. 9 is another diagram of a relationship between a power module and a vertical insulation plate according to an embodiment of this application.

In an embodiment, with reference to FIG. 9, in the arrangement direction of the at least two electrical connectors 222, a sum of lengths of two adjacent electrical connectors 222 and a length of a gap between the two adjacent electrical connectors 222 is less than or equal to a length of the horizontal insulation plate 231, and the length of the horizontal insulation plate 231 is less than a length of the packaging housing 221.

In this embodiment of this application, with reference to FIG. 9, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. In the Y direction, the vertical insulation plate 230 separates the two adjacent copper bar connectors 222a, a horizontal insulation plate 231 extends toward two sides of the vertical insulation plate 230 in the Y direction, and a sum of lengths of the two adjacent copper bar connectors 222a and a length of a gap between the adjacent copper bar connectors 222a is less than or equal to a length of the horizontal insulation plate 231. In this way, the horizontal insulation plate 231 can fully protect the packaging housing 221 and the copper bar connectors 222a, to avoid creepage between the two adjacent copper bar connectors 222a along a surface of the packaging housing 221, and increase a creepage distance between the two adjacent copper bar connectors 222a, so as to avoid a short circuit of the power module 220. In the Y direction, the length of the horizontal insulation plate 231 is less than a length of the packaging housing 221. The length of the horizontal insulation plate 231 is not beyond the length of the packaging housing 221, to avoid interference in mounting of another electrical component.

In this embodiment of this application, with reference to FIG. 9, the side of the power module in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b. In the Y direction, a horizontal insulation plate 231 extends in a direction of the copper bar connector 222a, two vertical insulation plates 230 are jointly fastened to the horizontal insulation plate 231, and a length of the copper bar connector 222a is less than or equal to a length of the horizontal insulation plate 231. In this way, the horizontal insulation plate 231 can fully protect the packaging housing 221 and the copper bar connector 222a, to avoid creepage, along a surface of the packaging housing 221, between the plurality of pins 222b and the copper bar connector 222a that are adjacent, and increase a creepage distance between two adjacent electrical connectors 222, so as to avoid a short circuit of the power module 220. In the Y direction, the length of the horizontal insulation plate 231 is less than a length of the packaging housing 221. The length of the horizontal insulation plate 231 is not beyond the length of the packaging housing 221, to avoid interference in mounting of another electrical component.

In an embodiment, the two vertical insulation plates 230 and the horizontal insulation plate 231 are independent structures that can be separated from each other, and the two vertical insulation plates 230 may be fastened to the horizontal insulation plate 231 by using an adhesive, a fastener, a screw, or the like. Alternatively, the two vertical insulation plates 230 and the horizontal insulation plate 231 are an integrated structure, and the horizontal insulation plate 231 is synchronously formed during integrated injection molding.

In an embodiment, still with reference to FIG. 9, the horizontal insulation plate 231 includes a protruding strip 2311, and the protruding strip 2311 extends in the Y direction. In the Y direction, a length of the protruding strip 2311 is less than or equal to the length of the horizontal insulation plate 231, and in the X direction, a length of the protruding strip 2311 is less than a length of the horizontal insulation plate 231. The protruding strip is configured to fit with another electrical component or another fastened plate, to increase an insulation distance between the horizontal insulation plate 231 and another electrical component.

In an embodiment, the horizontal insulation plate 231 extends for a specific length in the X reverse direction, and in the X direction, a sum of the extended length of the horizontal insulation plate 231 and a length of the liquid cooling radiator 210 is less than or equal to a length of the power module 220, to save mounting space.

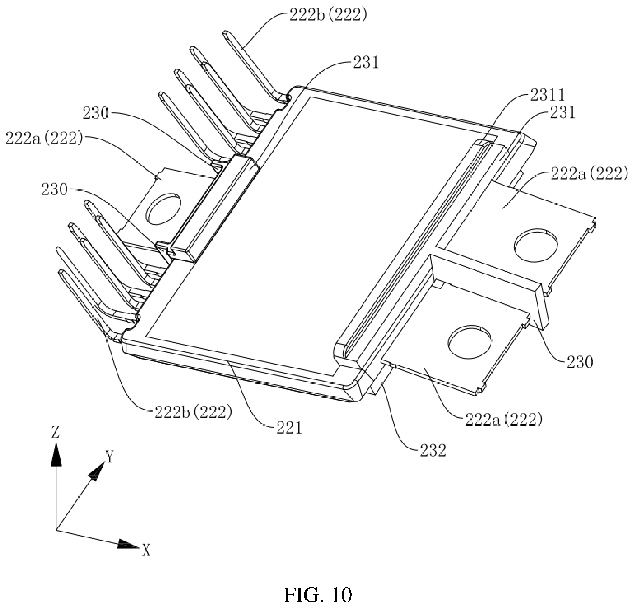

In an embodiment, with reference to FIG. 10, the power module 220 further includes another horizontal insulation plate 232, the another horizontal insulation plate 232 extends in the thickness direction of the vertical insulation plate 230, and the another horizontal insulation plate 232 is configured to: be located on two sides of the packaging housing 221 with the horizontal insulation plate 232 in the thickness direction of the liquid cooling radiator 210, protrude from another surface of the packaging housing 221, and connect to the vertical insulation plate 230.

In this embodiment of this application, the side of the power module in the X positive direction is an alternating-current power terminal side, and the alternating-current power terminal side of the power module includes two electrical connectors 222. Both the two electrical connectors 222 are copper bar connectors 222a, including one positive copper bar connector and one negative copper bar connector. The vertical insulation plate 230 includes another horizontal insulation plate 232 extending in the X reverse direction. In the Y direction, the horizontal insulation plate 231 separately extends in directions of the two electrical connectors 222. The another horizontal insulation plate 232 is configured to be located on two sides of the packaging housing 221 with the horizontal insulation plate 231 in the thickness direction of the liquid cooling radiator 210. The another horizontal insulation plate 232 is attached to the packaging housing 221, and is attached to the packaging housing 221 with the horizontal insulation plate 231. The another horizontal insulation plate 232 and the horizontal insulation plate 231 are configured to jointly clamp the vertical insulation plate 230, to prevent the vertical insulation plate 230 from detaching during working of the vehicle-mounted power supply apparatus 200, so as to ensure stability of the vertical insulation plate 230 on the vehicle-mounted power supply apparatus 200 during working.

In an embodiment, the another horizontal insulation plate 232 extends for a specific length in the X reverse direction, and in the X direction, the extended length of the another horizontal insulation plate 232 is equal to the extended length of the horizontal insulation plate 231.

In an embodiment, the vertical insulation plate 230 and the another horizontal insulation plate 232 are independent structures that can be separated from each other, and the vertical insulation plate 230 may be fastened to the another horizontal insulation plate 232 by using an adhesive, a fastener, a screw, or the like, so that the vertical insulation plate 230 is attached to the another horizontal insulation plate 232. In an embodiment, the vertical insulation plate 230, the horizontal insulation plate 231, and the another horizontal insulation plate 232 are an integrated structure. The horizontal insulation plate 231 and the another horizontal insulation plate 232 are synchronously formed during integrated injection molding, so that the horizontal insulation plate 231 and the another horizontal insulation plate 232 have high connection strength.

In this embodiment of this application, with reference to FIG. 10, the side of the power module in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b. There are two vertical insulation plates 230, which are located between two adjacent electrical connectors 222. The vertical insulation plate 230 includes another horizontal insulation plate 232. The another horizontal insulation plate 232 extends in the X positive direction. The another horizontal insulation plate 232 is configured to be located on two sides of the packaging housing 221 with the horizontal insulation plate 231 in the thickness direction of the liquid cooling radiator 210. The another horizontal insulation plate 232 is attached to the packaging housing 221, and is attached to the packaging housing 221 with the horizontal insulation plate 231. The another horizontal insulation plate 232 and the horizontal insulation plate 231 are configured to jointly clamp the vertical insulation plate 230, to prevent the vertical insulation plate 230 from detaching during working of the vehicle-mounted power supply apparatus 200, so as to ensure stability of the vertical insulation plate 230 on the vehicle-mounted power supply apparatus 200 during working.

In an embodiment, with reference to FIG. 10, in the Y direction, the vertical insulation plate 230 separates the two adjacent electrical connectors 222, the another horizontal insulation plate 232 extends toward the two sides of the vertical insulation plate 230 in the Y direction, and a sum of lengths of the two adjacent electrical connectors 222 and a length of a gap between the two adjacent electrical connectors 222 is less than or equal to a length of the another horizontal insulation plate 232. In the Y direction, the length of the another horizontal insulation plate 232 is less than the length of the packaging housing 221, and the length of the another horizontal insulation plate 232 is equal to the length of the horizontal insulation plate 231. In an embodiment, in the Y direction, the length of the another horizontal insulation plate is less than the length of the horizontal insulation plate 231. In an embodiment, in the Y direction, the length of the another horizontal insulation plate is greater than the length of the horizontal insulation plate 231.

In an embodiment, still with reference to FIG. 10, the horizontal insulation plate 231 and the another horizontal insulation plate 232 are disposed opposite to each other in the Z direction. Specifically, the horizontal insulation plate 231 and the another horizontal insulation plate 232 are respectively attached to two sides of the packaging housing 221 in the Z direction. Disposing the another horizontal insulation plate 232 can increase an area for protecting the packaging housing 221. The horizontal insulation plate 231 and the another horizontal insulation plate 232 can clamp the packaging housing 221 and the vertical insulation plate 230, to prevent the vertical insulation plate 230 from detaching during working of the vehicle-mounted power supply apparatus 200, so as to ensure stability of the vertical insulation plate 230 on the vehicle-mounted power supply apparatus 200 during working. This better protects the power module 220, and avoids a short circuit of the power module 220.

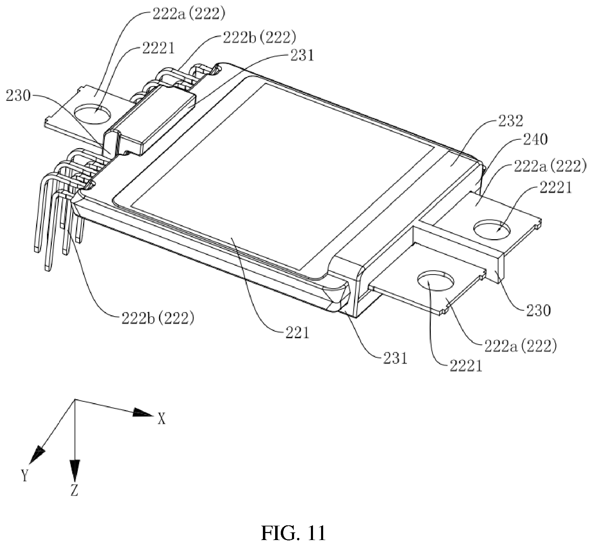

FIG. 11 is another diagram of a relationship between a power module and a vertical insulation plate according to an embodiment of this application.

In an embodiment, with reference to FIG. 11, the vehicle-mounted power supply apparatus 200 includes a connection plate 240, the vertical insulation plate 230 is configured to be fastened to the connection plate 240, and the connection plate 240 is configured to connect to the horizontal insulation plate 231 and the another horizontal insulation plate 232 in the thickness direction of the liquid cooling radiator 210.

In this embodiment of this application, still with reference to FIG. 11, an end surface on a side that is of the packaging housing 221 and that faces the vertical insulation plate 230 is a smooth horizontal plane, the vehicle-mounted power supply apparatus 200 includes a connection plate 240, and the connection plate 240 extends in the Z direction and is attached to the plane. The vertical insulation plate 230 is fastened to the connection plate 240, and the vertical insulation plate 230 is perpendicular to the connection plate 240 in the X direction. This can enhance stability of connection between the connection plate 240 and a plurality of electrical connectors 222, to increase the creepage distance between the two adjacent electrical connectors 222 along the surface of the packaging housing 221. In the X positive direction, an end surface of the horizontal insulation plate 231 and an end surface of the another horizontal insulation plate 232 are located on a same side of the plane of the packaging housing 221. The connection plate 240 is connected to the horizontal insulation plate 231 and the another horizontal insulation plate 232 in the Z direction, to fasten the horizontal insulation plate 231 and the another horizontal insulation plate 232.

In an embodiment, the connection plate 240 has a specific width in the X positive direction. In the Z direction, a length of the connection plate 240 is equal to a sum of lengths of the horizontal insulation plate 231, the another horizontal insulation plate 232, and the packaging housing 221. The length of the connection plate 240 is not beyond the lengths of the horizontal insulation plate 231 and the another horizontal insulation plate 232, to avoid interference in mounting of another electrical component.

In an embodiment, the horizontal insulation plate 231, the another horizontal insulation plate 232, and the connection plate 240 jointly enclose an accommodation part, an opening of the accommodation part faces a side wall of the packaging housing 221 in the X direction, and the accommodation part is configured to accommodate a side edge on the side that is of the packaging housing 221 and that faces the vertical insulation plate 230, so that the accommodation part clamps the two sides of the packaging housing 221 in the Z direction. This enhances stability of connection between the connection plate 240 and the plurality of electrical connectors 222, increases the creepage distance between the two adjacent electrical connectors 222 along the surface of the packaging housing 221, and improves effect of protecting the packaging housing 221.

In an embodiment, the connection plate 240 is fastened to the horizontal insulation plate 231 and the another horizontal insulation plate 232, and the connection plate 240 may be fastened to the horizontal insulation plate 231 and the another horizontal insulation plate 232 by using an adhesive, a fastener, a bolt, or the like. Alternatively, the connection plate 240, the horizontal insulation plate 231, and the another horizontal insulation plate 232 are an integrated structure, are formed through integrated injection molding, and have high connection strength.

In an embodiment, the vertical insulation plate 230 is fastened to the connection plate 240, and the vertical insulation plate 230 may be fastened to the connection plate 240 by using an adhesive, a fastener, a screw, or the like. Alternatively, the vertical insulation plate 230 and the connection plate 240 are an integrated structure, and are formed through integrated injection molding.

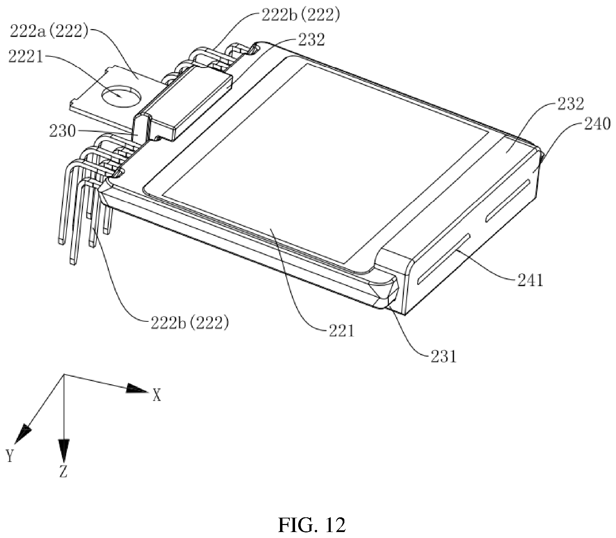

FIG. 12 is another diagram of a relationship between a power module and a vertical insulation plate according to an embodiment of this application.

In an embodiment, with reference to FIG. 12, the connection plate 240 includes a through hole 241, and the through hole 241 is configured to: run through the connection plate 240 in an arrangement direction of the electrical connector 222 and the packaging housing 221, and accommodate the electrical connector 222.

In this embodiment of this application, with reference to FIG. 12, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. A through hole 241 is provided on a connection plate in the X direction, and the through hole 241 runs through the connection plate 240 in the X direction. The through hole 241 is strip-shaped, and is configured to accommodate a copper bar connector 222a. The copper bar connector 222a is configured to pass through the through hole 241. In the Y direction, a length of the through hole 241 is equal to a length of the copper bar connector 222a. In the Z direction, a length of the through hole 241 is equal to a length of the copper bar connector 222a. In the Y direction, two sides of the copper bar connector 222a are attached to two sides of an inner wall of the through hole 241, and in the Z direction, two sides of the copper bar connector 222a abut against two sides of an inner wall of the through hole 241, to enhance stability of connection between the copper bar connector 222a and the through hole 241, and prevent the copper bar connector 222a from sliding. In an embodiment, in the Y direction, the length of the through hole 241 is greater than the length of the copper bar connector 222a, in the Z direction, the length of the through hole 241 is greater than the length of the copper bar connector 222a, and the through hole 241 is configured to accommodate the copper bar connector 222a.

In an embodiment, there are two through holes 241, the through holes 241 with a same shape and size are respectively provided on the connection plate 240 on the two sides of the vertical insulation plate 230 in the Y direction, and each through hole 241 is configured to accommodate one of the copper bar connectors 222a located on the two sides of the vertical insulation plate 230, to enhance structural stability of each copper bar connector 222a and the through hole 241 configured to accommodate the copper bar connector 222a, prevent the copper bar connector 222a from sliding, and ensure stability of the copper bar connector 222a.

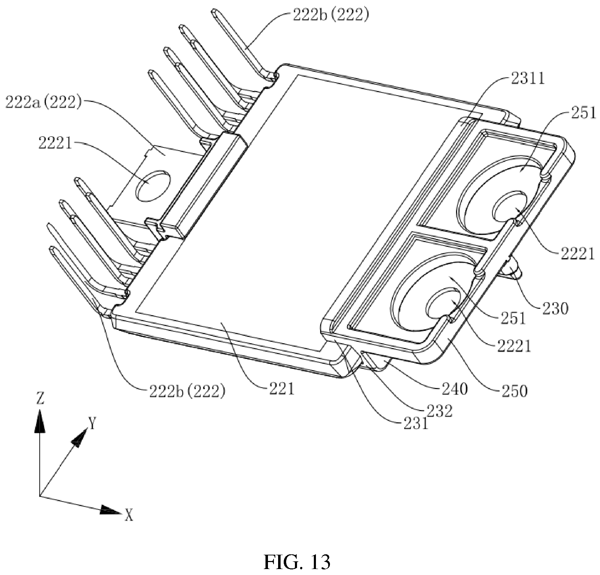

FIG. 13 is another diagram of a relationship between a power module and a vertical insulation plate according to an embodiment of this application.

In an embodiment, with reference to FIG. 13, the vehicle-mounted power supply apparatus 200 includes another connection plate 250, the vertical insulation plate 230 is configured to be fastened to the another connection plate 250, the another connection plate 250 is configured to be located on a same side of the electrical connector 222 as the liquid cooling radiator 210 in the thickness direction of the liquid cooling radiator 210, the another connection plate 250 includes another through hole 251, and the another through hole 251 is configured to run through the another connection plate 250 in the thickness direction of the liquid cooling radiator 210.

In this embodiment of this application, with reference to FIG. 13, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. The vehicle-mounted power supply apparatus 200 includes another connection plate 250. The another connection plate 250 and the liquid cooling radiator 210 are located on a same side of the electrical connector 222 in the Z direction. The vertical insulation plate 230 is fastened to the connection plate 240, and the vertical insulation plate 230 is perpendicular to the another connection plate 250. The another connection plate 250 and the electrical connector 222 are sequentially stacked in the Z direction, to separate the electrical connector 222 from another electrical component, so as to avoid interference of the another electrical component to the electrical connector 222.

In an embodiment, with reference to FIG. 13, both the vertical insulation plate 230 and the horizontal insulation plate 231 are fastened to the another connection plate 250, the horizontal insulation plate 231 is connected to the another connection plate 250 in the X direction, the another connection plate 250 extends for a specific length in the X positive direction, and a bottom wall of the another connection plate 250 and a bottom wall of the horizontal insulation plate 231 are located on a same horizontal plane.

In this embodiment of this application, with reference to FIG. 13, the vertical insulation plate 230 may be trapezoid-shaped, and a width of the vertical insulation plate 230 in the Y direction gradually extends in the Z positive direction, to be fastened to the another connection plate 250. The vertical insulation plate 230 is trapezoid-shaped, so that a part at which the vertical insulation plate 230 is connected to the another connection plate 250 has better connection stability, to prevent the vertical insulation plate 230 from detaching during working of the vehicle-mounted power supply apparatus 200, so as to ensure stability of connection between the vertical insulation plate 230 and the another connection plate 250.

In this embodiment of this application, with reference to FIG. 13, another through hole 251 is provided on the another connection plate 250 in the Z direction, and the another through hole 251 runs through the another connection plate 250 in the Z direction. The another through hole 251 is circular, or may be in another shape. The another through hole 251 is configured to run through the another connection plate 250 in the Z direction. The copper bar connector 222a includes a copper bar through hole 2221. The copper bar through hole 2221 is circular, or may be in another shape. The copper bar through hole 2221 is configured to run through the copper bar connector 222a in the Z direction. The copper bar through hole 2221 and the another through hole 251 are provided opposite to each other in the Z direction. In the X direction, an inner diameter of the copper bar through hole 2221 is less than an inner diameter of the another through hole 251. Each of the copper bar through hole 2221 and the another through hole 251 is configured to connect to another electrical component.

In an embodiment, the copper bar through hole 2221 and the another through hole 251 are provided opposite to each other in the Z direction. In the X direction, the inner diameter of the copper bar through hole 2221 is equal to the inner diameter of the another through hole 251. Each of the copper bar through hole 2221 and the another through hole 251 is configured to connect to another electrical component.

In an embodiment, with reference to FIG. 13, in the arrangement direction of the at least two electrical connectors 222, a length of the another connection plate 250 is greater than or equal to a length of at least one electrical connector 222, and a length of the another connection plate 250 on a side of the vertical insulation plate 230 is less than or equal to a length of the packaging housing on the same side of the vertical insulation plate 230.

In this embodiment of this application, with reference to FIG. 13, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. The another connection plate 250 and a copper bar connector 222a are disposed opposite to each other in the Z direction, and in the Y direction, a length of the another connection plate 250 is greater than a length of the copper bar connector 222a disposed corresponding to the another connection plate 250, so that the another connection plate 250 can fully bear the copper bar connector 222a. In an embodiment, the another connection plate 250 and the copper bar connector 222a are disposed opposite to each other in the Z direction, and in the Y direction, the length of the another connection plate 250 is equal to the length of the copper bar connector 222a disposed corresponding to the another connection plate 250.

In this embodiment of this application, still with reference to FIG. 13, in the Y direction, the another connection plate 250 is disposed on any one of the two sides of the vertical insulation plate 230, and a length of the another connection plate 250 on the side of the vertical insulation plate 230 is less than a length of the packaging housing on the same side of the vertical insulation plate 230. In the Y direction, a side of the another connection plate 250 does not protrude from a side of the packaging housing 221 on the same side, to avoid interference in mounting of another electrical component. In an embodiment, in the Y direction, the another connection plate 250 is disposed on any one of the two sides of the vertical insulation plate 230, and the length of the another connection plate 250 on the side of the vertical insulation plate 230 is equal to the length of the packaging housing on the same side of the vertical insulation plate 230. In the Y direction, the side of the another connection plate 250 does not protrude from the side of the packaging housing 221 on the same side, to avoid interference in mounting of another electrical component.

In an embodiment, with reference to FIG. 13, there are at least two other connection plates 250, and there may be two, three, or four other connection plates 250 or the like. The at least two other connection plates 250 are located on the two sides of the vertical insulation plate 230 in the arrangement direction of the at least two electrical connectors 222.

In this embodiment of this application, with reference to FIG. 13, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. For example, there are two other connection plates 250. There are two other connection plates 250. In the Y direction, the two other connection plates 250 are sequentially disposed, and distributed on the two sides of the vertical insulation plate 230. In the Y direction, bottom walls of the two other connection plates 250 are located on a same horizontal plane.

In an embodiment, in the Y direction, a sum of lengths of the two other connection plates 250 is greater than a sum of lengths of the two adjacent copper bar connectors 222a and a length of a gap between the two adjacent copper bar connectors 222a, to protect each copper bar connector 222a. In the Y direction, the sum of the lengths of the two other connection plates 250 is less than the length of the packaging housing 221. The lengths of the other connection plates 250 are not beyond the length of the packaging housing 221, to avoid interference in mounting of another electrical component. In an embodiment, in the Y direction, the sum of the lengths of the two other connection plates 250 is equal to the sum of the lengths of the two adjacent copper bar connectors 222a and the length of the gap between the two adjacent copper bar connectors 222a. In an embodiment, in the Y direction, the sum of the lengths of the two other connection plates 250 is equal to the length of the packaging housing 221.

In an embodiment, there are two other through holes, the other through holes 251 with a same shape and size are respectively provided on the two other connection plates 250 in the Y direction, and the two other through holes 251 are distributed on the two sides of the vertical insulation plate 230. Each of the other through holes 251 is provided opposite to one of copper bar through holes 2221, and each of the other through holes 251 is configured to connect to another electrical component.

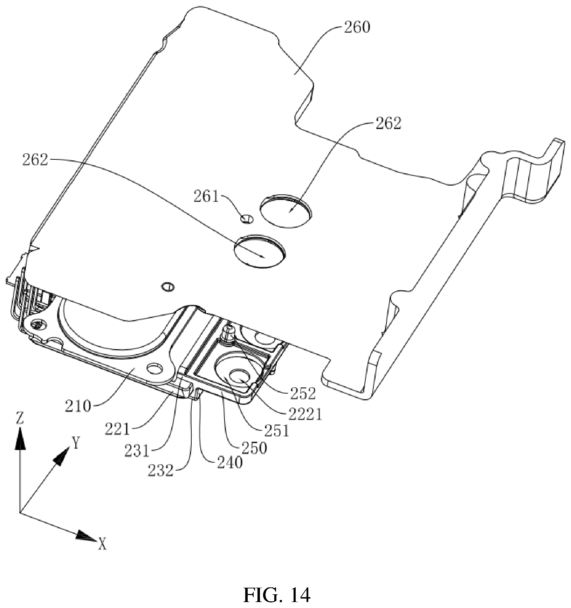

FIG. 14 is a diagram of a relationship between a fastened plate, a liquid cooling radiator, and a power module according to an embodiment of this application.

In an embodiment, with reference to FIG. 14, the vehicle-mounted power supply apparatus 200 includes a fastened plate 260, the fastened plate 260, the liquid cooling radiator 210, and the power module 220 are sequentially arranged in the thickness direction of the liquid cooling radiator 210, the fastened plate 260 includes a third through hole 261, an outer wall surface on a side that is of the another connection plate 250 and that faces the fastened plate 260 includes a third protrusion 252, and the third protrusion 252 is configured to pass through the third through hole 261 in the thickness direction of the liquid cooling radiator 210.

In this embodiment of this application, with reference to FIG. 14, the vehicle-mounted power supply apparatus 200 includes the fastened plate, and the fastened plate 260, the liquid cooling radiator 210, and the power module 220 are sequentially stacked in the Z direction. In the X direction, a length of the fastened plate 260 is greater than a length of the liquid cooling radiator 210, and in the Y direction, a length of the fastened plate 260 is greater than a length of the liquid cooling radiator 210. The fastened plate 260 is configured to be fastened to the liquid cooling radiator 210, to enhance stability of the liquid cooling radiator 210.

In an embodiment, the fastened plate 260 may be fastened to the liquid cooling radiator 210 by using an adhesive, a fastener, a screw, or the like, to fasten the fastened plate 260 to the liquid cooling radiator 210, so that the fastened plate 260 is attached to the liquid cooling radiator 210.

In this embodiment of this application, with reference to FIG. 14, the third through hole 261 is provided on the fastened plate 260, and the third through hole 261 runs through the fastened plate 260 in the Z direction. The third through hole 261 is a circular hole, or may be in another shape. The third protrusion 252 is disposed on the outer wall surface on the side that is of the another connection plate 250 and that faces the fastened plate 260. The third protrusion 252 is a cylindrical protrusion, or may be in another shape. An inner diameter of the third through hole 261 is greater than an outer diameter of the third protrusion 252. The third protrusion 252 is configured to pass through the third through hole 261 in the Z direction, to fasten the another connection plate 250, so as to prevent the another connection plate 250 from sliding leftward or rightward, and ensure stability of the vertical insulation plate 230. In an embodiment, the third through hole 261 is a circular hole, the third protrusion 252 is a cylindrical protrusion, and the inner diameter of the third through hole 261 is equal to the outer diameter of the third protrusion 252.

In this embodiment of this application, still with reference to FIG. 14, a fourth through hole 262 is provided on the fastened plate 260, there are two fourth through holes 262, and the fourth through hole 262 runs through the fastened plate 260 in the Z direction. The fourth through hole 262 is a circular hole, or may be in another shape. The fourth through hole 262 and the another through hole 251 are provided opposite to each other in the Z direction. In the X direction, an inner diameter of the fourth through hole 262 is greater than or equal to the inner diameter of the another through hole 251, to ensure that the fourth through hole 262 and the another through hole 251 can be configured to connect to another electrical component.

In an embodiment, still with reference to FIG. 13, the vehicle-mounted power supply apparatus 200 includes at least three electrical connectors 222, and there may be three or four electrical connectors 222 or the like. The at least three electrical connectors 222 are located on a same side of the packaging housing 221 in a direction perpendicular to the thickness of the liquid cooling radiator 210, and at least one vertical insulation plate 230 is included between any two adjacent electrical connectors 222 in an arrangement direction of the at least three electrical connectors 222.

In this embodiment of this application, still with reference to FIG. 12, the side of the power module 220 in the X reverse direction is a direct-current power terminal side configured to convert a direct current into a direct current for output, and the direct-current power terminal side of the power module 220 includes three electrical connectors 222. One electrical connector 222 is a copper bar connector 222a, the other two electrical connectors 222 are a plurality of pins 222b, and the copper bar connector 222a is located between the plurality of pins 222b in the Y direction.

In an embodiment, still with reference to FIG. 12, a vertical insulation plate 230 is disposed between the copper bar connector 222a and the plurality of pins 222b in the Y direction. In other words, a vertical insulation plate 230 is disposed between any two adjacent electrical connectors 222. The vertical insulation plate 230 extends in the Z direction. In the X direction, a side wall that is of the vertical insulation plate 230 and that faces the packaging housing 221 is connected to a side wall that is of the packaging housing 221 and that corresponds to the side wall of the vertical insulation plate 230. The vertical insulation plate 230 is disposed between the any two adjacent electrical connectors 222, to increase an electrical clearance and a creepage distance between the any two adjacent electrical connectors 222, so as to ensure safety of the any two adjacent electrical connectors 222 and avoid a short circuit of the power module 220.

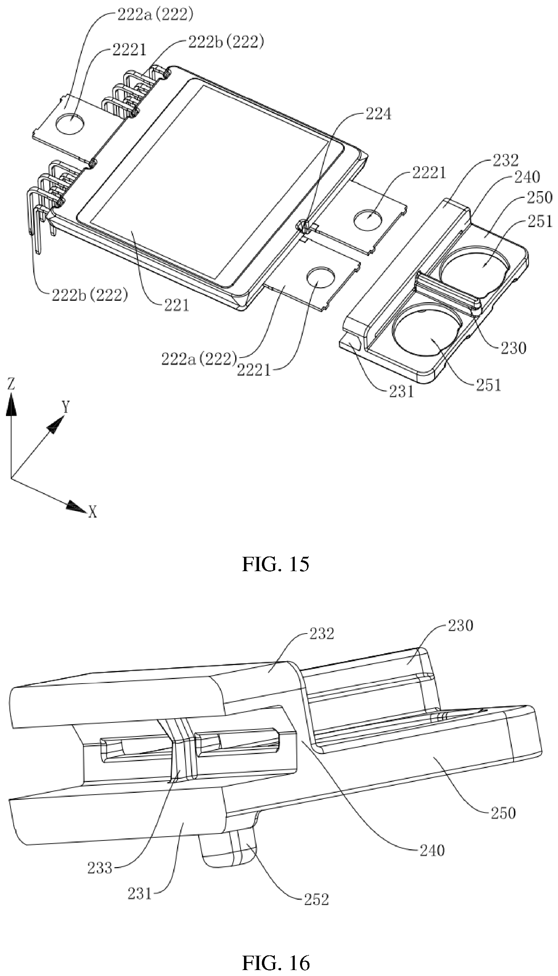

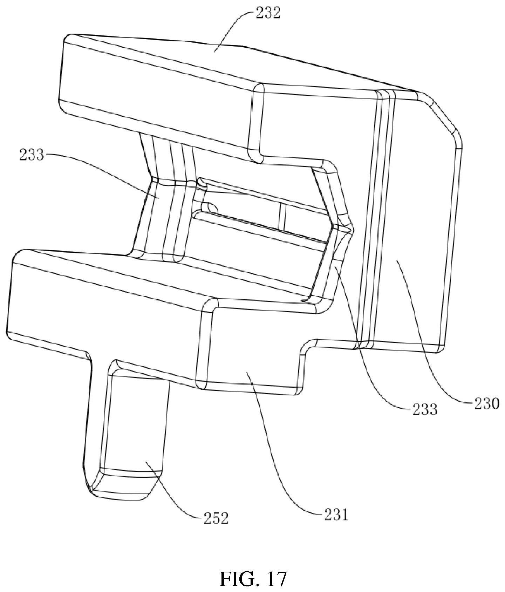

FIG. 15 is another diagram of a relationship between a power module and a vertical insulation plate according to an embodiment of this application. FIG. 16 is a diagram of a vertical insulation plate according to an embodiment of this application. FIG. 17 is another diagram of a vertical insulation plate according to an embodiment of this application.

In an embodiment, with reference to FIG. 15, a side edge on a side of the packaging housing 221 includes a recess 224, the recess 224 is configured to accommodate a side edge on a side of the vertical insulation plate 230, in the arrangement direction of the at least two electrical connectors 222, a length of the recess 224 is equal to a length of the vertical insulation plate 230, and in the arrangement direction of the electrical connector 222 and the packaging housing 221, the side edge on the side of the vertical insulation plate 230 is configured to be attached to a bottom wall of the recess.

In this embodiment of this application, with reference to FIG. 15, the packaging housing 221 includes two opposite sides in the X direction. A side edge on a side of the packaging housing 221 includes a recess 224. The recess 224 is configured to accommodate a side edge on a side that is of the vertical insulation plate 230 and that faces the packaging housing 221 in the X direction. In the Y direction, a length of the recess 224 is equal to a length of the side edge on the side of the vertical insulation plate 230 accommodated by the recess 224. In the X reverse direction, the side edge on the side of the vertical insulation plate 230 abuts against a bottom wall of the recess 224, to be attached to the recess 224. In this way, the vertical insulation plate 230 fits with the recess 224, to avoid occurrence of a gap, so as to avoid a short circuit, a failure, or the like of the power module 220 caused by flowing of condensate water or other impurities into the gap.

In an embodiment, in the Z direction, a length of the recess 224 is equal to a length of the vertical insulation plate 230 accommodated by the recess 224, in the X reverse direction, the side edge on the side of the vertical insulation plate 230 abuts against the bottom wall of the recess 224, and in the X reverse direction, the side edge on the side of the vertical insulation plate 230 abuts against an inner wall disposed opposite to the bottom wall of the recess 224, so that the vertical insulation plate 230 is in an interference fit with the recess 224.

In an embodiment, with reference to FIG. 15 and FIG. 16, the side of the power module in the X positive direction is an alternating-current power terminal side, and the alternating-current power terminal side of the power module includes two electrical connectors 222. Both the two electrical connectors 222 are copper bar connectors 222a. There is one vertical insulation plate 230, and there is one recess 224 on a side edge on a side of the packaging housing 221 in the X positive direction. The recess 224 is located between the two copper bar connectors 222a, to increase an electrical clearance and a creepage distance between the two adjacent copper bar connectors 222a, so as to avoid creepage between the two adjacent electrical connectors 222. The vertical insulation plate 230 includes a protrusion 233 in the X direction. There is one protrusion 233, the protrusion 233 is perpendicular to the horizontal insulation plate 231 and the another horizontal insulation plate 232, and the protrusion 233 is parallel to the connection plate 240. In the X direction, the recess 224 is configured to accommodate the protrusion 233 of the vertical insulation plate 230. In the Y direction, a length of the recess 224 is equal to a length of the protrusion 233. In the Z direction, a length of the recess 224 is equal to a length of the protrusion 233. In the X direction, a bottom wall of the recess 224 abuts against a bottom wall of the protrusion 233. In this way, the protrusion 233 is in an interference fit with the recess 224, to avoid occurrence of a gap, so as to avoid creepage between the two adjacent copper bar connectors 222a caused by flowing of condensate water or other impurities into the gap, so that the power module 220 does not short-circuit, fail, or the like.

In an embodiment, with reference to FIG. 15 and FIG. 17, the side of the power module 220 in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b in the Y direction. There are two vertical insulation plates 230, and there are two recesses 224 on a side edge on a side of the packaging housing 221 in the X reverse direction. The two recesses 224 are separately provided between the copper bar connector 222a and the plurality of pins 222b adjacent to the copper bar connector 222a, to increase a clearance and an insulation distance between the copper bar connector 222a and the plurality of pins 222b adjacent to the copper bar connector 222a. The vertical insulation plate 230 includes a protrusion 233 in the X direction. There are two protrusions 233, the protrusion 233 is perpendicular to the horizontal insulation plate 231 and the another horizontal insulation plate 232, and the protrusion 233 is parallel to the connection plate 240. In the X direction, the recess 224 is configured to accommodate the protrusion 233 of the vertical insulation plate 230. In the Y direction, a length of the recess 224 is equal to a length of the accommodated protrusion 233. In the Z direction, a length of the recess 224 is equal to a length of the accommodated protrusion 233. In the X direction, a bottom wall of the recess 224 abuts against a bottom wall of the accommodated protrusion 233. In this way, the recess 224 is in an interference fit with the accommodated protrusion 233, to avoid occurrence of a gap, so as to avoid creepage between the plurality of pins 222b and the copper bar connector 222a that are adjacent caused by flowing of condensate water or other impurities into the gap, so that the power module 220 does not short-circuit, fail, or the like.

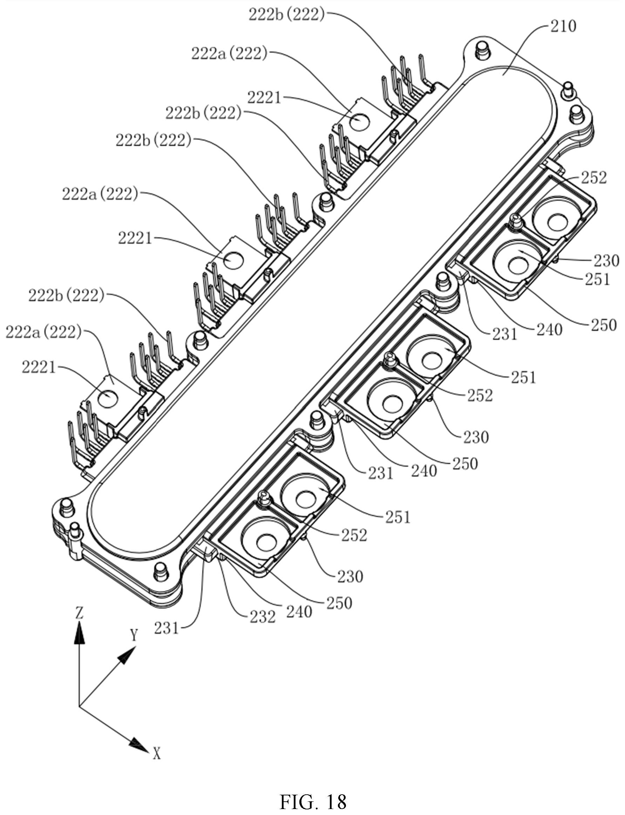

FIG. 18 is another diagram of a vehicle-mounted power supply apparatus according to an embodiment of this application.

In an embodiment, with reference to FIG. 18, there are at least two power modules 220, and there may be two, three, or four power modules 220 or the like. The power modules 220 are sequentially arranged in the Y direction, and two adjacent power modules 220 are fastened by using a bolt or the like, to ensure stability of the power modules 220.

In an embodiment, with reference to FIG. 18, there are two liquid cooling radiators 210, one liquid cooling radiator 210 is located on a side of the power module 220 in the Z positive direction, the other liquid cooling radiator 210 is located on a side of the power module 220 in a Z reverse direction, the two liquid cooling radiators 210 are sandwiched between the power modules 220, a water path is disposed in each of the two liquid cooling radiators 210, and water paths in the two liquid cooling radiators 210 are in a connected state and are configured to dissipate heat from the power modules 220, to improve cooling effect and achieve better heat dissipation efficiency.

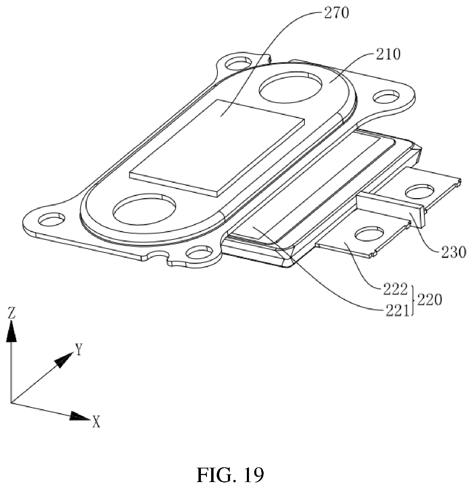

FIG. 19 is another diagram of a vehicle-mounted power supply apparatus according to an embodiment of this application.

In an embodiment, with reference to FIG. 19, the vehicle-mounted power supply apparatus 200 includes a water absorption layer 270, the liquid cooling radiator 210 is configured to be fastened to the water absorption layer 270, and the water absorption layer 270, the liquid cooling radiator 210, and the power module 220 are sequentially arranged in the thickness direction of the liquid cooling radiator 210.

In this embodiment of this application, with reference to FIG. 19, the vehicle-mounted power supply apparatus 200 includes the water absorption layer 270, and the water absorption layer 270, the liquid cooling radiator 210, and the power module 220 are sequentially arranged in the Z direction. In the X direction, a length of the water absorption layer 270 is less than the length of the liquid cooling radiator 210, and in the Y direction, a length of the water absorption layer 270 is less than the length of the liquid cooling radiator 210. The liquid cooling radiator 210 is configured to be fastened to the water absorption layer 270, to enhance stability of the water absorption layer 270.

In an embodiment, the water absorption layer 270 may be fastened to the liquid cooling radiator 210 by using an adhesive, to fasten the water absorption layer 270 to the liquid cooling radiator 210, so that the water absorption layer 270 is attached to the liquid cooling radiator 210.

In an embodiment, a material of the water absorption layer 270 includes a water absorption material such as porous foam or sponge, to absorb condensate water generated by the liquid cooling radiator 210 in a process of cooling the power module 220, so as to avoid a short circuit of the power module 220 caused by flowing of the condensate water generated by the liquid cooling radiator 210 to the power module 220.

In an embodiment, there are two liquid cooling radiators 210, and there are two water absorption layers 270. One water absorption layer 270 is disposed on a side that is of each liquid cooling radiator 210 and that faces away from the power module 220 in the Z direction, to absorb condensate water generated by the liquid cooling radiator 210 in a process of cooling the power module 220.

An embodiment of this application provides a powertrain. Refer to FIG. 1 and FIG. 2. The powertrain 10 includes a drive motor 100, a vehicle-mounted power supply apparatus 200, and a reducer 300. In an embodiment, the reducer 300 includes a single-speed reducer, a two-speed reducer, or a transmission. In an embodiment, the reducer 300 includes an input shaft 310, an intermediate shaft 320, and an output shaft 330. As shown in FIG. 2, the reducer 300 includes the input shaft 310, the intermediate shaft 320, and the output shaft 330. The input shaft 310 is configured to be in transmission connection to the drive motor 100 and the intermediate shaft 320, the intermediate shaft 320 is configured to be in transmission connection to the output shaft 330, and the output shaft 330 is configured to be in transmission connection to a wheel 40. In an embodiment, the reducer 300 is in transmission connection to two wheels 40 through two half shafts 50 respectively. In an embodiment, the vehicle-mounted power supply apparatus 200 is configured to: receive an alternating current, and convert the alternating current into a direct current to charge a power battery 30. In an embodiment, the vehicle-mounted power supply apparatus 200 is configured to: receive a high-voltage direct current, and supply the direct current to the power battery 30 for charging. In an embodiment, the vehicle-mounted power supply apparatus includes a vehicle-mounted charger, a motor control unit, a direct current-direct current converter, or another vehicle-mounted power supply apparatus.

In an embodiment, the vehicle-mounted power supply apparatus 200 is configured to: receive a direct current of the power battery 30, convert the direct current into an alternating current, and transmit the alternating current to the drive motor 100. The drive motor 100 converts electric energy into mechanical energy. The drive motor 100 is configured to be in transmission connection to the reducer 300. The drive motor 100 drives, through the reducer 300, a wheel 40 of an electric vehicle 1 to rotate. In an embodiment, the vehicle-mounted charger converts an alternating current of a power grid into a direct current, and transmits the direct current to the power battery 30 for charging. In an embodiment, the vehicle-mounted charger includes a direct current converter module. The direct current converter module converts a high-voltage direct current into a low-voltage direct current, to supply power to a low-voltage electrical system such as a light, a dashboard, or an air conditioner in the electric vehicle 1.

FIG. 3 is an assembly diagram of a powertrain according to an embodiment of this application. FIG. 4 is a diagram of the inside of a motor control unit container of a powertrain according to an embodiment of this application.

In an embodiment, with reference to FIG. 3 and FIG. 4, a housing 400 of the powertrain 10 includes a motor control unit container 410, a motor container 420, and a reducer container 430. This application provides a vehicle-mounted power supply apparatus. In embodiments of this application, a motor control unit is used as an example of the vehicle-mounted power supply apparatus 200. The motor control unit is merely an embodiment for description. During actual application, the vehicle-mounted power supply apparatus is not limited to the motor control unit. Other similar structures, for example, other vehicle-mounted power supply apparatuses including a liquid cooling radiator and a power module and having a vertical insulation plate, fall within the protection scope of this application. The vehicle-mounted power supply apparatus 200 is a part of the powertrain 10, and is integrated into the housing 400 of the powertrain 10. The motor control unit container 410 of the powertrain is configured to accommodate a plurality of electrical components of the motor control unit, including a component such as a capacitor or an inductor or a combination of components. The electrical component is configured to perform power supply conversion in the motor control unit. The motor container 420 and the reducer container 430 of the powertrain are distributed on two axial sides of the housing 400 of the powertrain. The motor container 420 is configured to accommodate the drive motor of the powertrain 10. An axis of the drive motor is parallel to an axis of the motor container 420. An orientation of an opening of the motor container 420 is opposite to an orientation of an opening of the reducer container 430 in an axial direction of the housing 400. The housing 400 of the powertrain includes a motor end cover and a reducer end cover, the motor end cover is configured to enclose the motor container 420, and the reducer end cover is configured to enclose the reducer container 430. The motor control unit container 410 is located on a radial side of the motor container 420, and an inner wall of the motor control unit container 410 may be a part of an outer wall surface of the motor container 420, to form an accommodation cavity with large capacity, so as to meet a mounting requirement of the vehicle-mounted power supply apparatus 200. In an embodiment, the housing 400 of the powertrain 10 and a housing of the vehicle-mounted power supply apparatus 200 are an integrated structure. In other words, the housing of the vehicle-mounted power supply apparatus 200 is the housing 400 of the powertrain 10. The housing 400 includes the motor control unit container 410. The motor control unit container 410 of the vehicle-mounted power supply apparatus is configured to accommodate a plurality of electrical components of the vehicle-mounted power supply apparatus 200. The electrical components refer to components such as a capacitor and an inductor or a combination of components, and are located in the vehicle-mounted power supply apparatus 200 for power supply conversion.

FIG. 5 is an exploded view of a vehicle-mounted power supply apparatus according to an embodiment of this application. FIG. 6 is another diagram of a vehicle-mounted power supply apparatus according to an embodiment of this application. FIG. 7 is a diagram of a relationship between a power module and a vertical insulation plate according to an embodiment of this application.

In an embodiment, with reference to FIG. 5, the vehicle-mounted power supply apparatus 200 includes a circuit board 201, a liquid cooling radiator 210, a power module 220, and a housing 202 of the vehicle-mounted power supply apparatus. The circuit board 201, the liquid cooling radiator 210, and the power module 220 are jointly integrated into the housing 202 of the vehicle-mounted power supply apparatus, to help optimize utilization of space of the vehicle-mounted power supply apparatus 200. The circuit board 201, the liquid cooling radiator 210, and the power module 220 are stacked in a thickness direction of the liquid cooling radiator 210, to achieve an efficient heat dissipation path. The circuit board 201 is configured to control operation of the power module 220. The liquid cooling radiator 210 is configured to dissipate heat from the circuit board 201 and the power module 220, to ensure normal working of the circuit board 201 and the power module 220. There may be one, two, or three liquid cooling radiators 210 or the like. Disposing a plurality of liquid cooling radiators 210 helps improve effect of dissipating heat from the power module 220 by the liquid cooling radiator 210. In an embodiment, the liquid cooling radiator 210 may be a single-layer heat dissipation plate structure. In an embodiment, the liquid cooling radiator 210 may be a double-layer heat dissipation plate structure, and the double-layer heat dissipation plate is symmetrically disposed on two sides of the power module 220. This helps improve effect of dissipating heat from the power module 220 by the heat dissipation plate, and temperature is even.

In an embodiment, with reference to FIG. 6 and FIG. 7, the vehicle-mounted power supply apparatus 200 includes the liquid cooling radiator 210 and the power module 220. The liquid cooling radiator 210 and the power module 220 are configured to be stacked in the thickness direction of the liquid cooling radiator 210, to achieve an efficient heat dissipation path. The thickness direction of the liquid cooling radiator 210 and a direction perpendicular to an axial direction of the motor control unit container 410 are a Z direction. The liquid cooling radiator 210 is located on a side of the power module 220 in a Z positive direction. In an embodiment, the power module 220 includes an insulated gate bipolar transistor (Insulated Gate Bipolar Transistor, IGBT) module, a silicon carbide power module, or the like, and is applicable to a high-voltage and high-power scenario of a new energy vehicle or the like.

In embodiments of this application, an IGBT module is used as an example of the power module. The IGBT module is merely an embodiment for description. During actual application, the power module is not limited to the IGBT module. Other similar power modules fall within the protection scope of this application. In an embodiment, the power module 220 includes a packaging housing 221 and at least two electrical connectors 222. The packaging housing 221 is configured to protect an internal structure of the power module 220, and has insulation and heat conduction functions. The at least two electrical connectors 222 are located on a same side of the packaging housing 221 in a direction perpendicular to a thickness of the liquid cooling radiator 210. A direction in which the packaging housing 221 faces the electrical connectors 222 is an X positive direction. The at least two electrical connectors 222 are located at two ends of an X direction. An arrangement direction of the at least two electrical connectors 222 is a Y direction. In an embodiment, a side of the packaging housing 221 in the X direction is an alternating-current power terminal side, configured to convert an alternating current into a direct current for output, and another side of the packaging housing 221 in the X direction is a direct-current power terminal side, configured to convert a direct current into a direct current for output. In an embodiment, the electrical connector 222 includes a copper bar connector, a pin, or the like, and the electrical connector 222 is configured to electrically connect to the packaging housing 221.

In an embodiment, the housing 400 of the powertrain 10 and the housing of the vehicle-mounted power supply apparatus 200 are an integrated structure. In other words, the housing of the vehicle-mounted power supply apparatus 200 is the housing 400 of the powertrain 10. The housing 400 includes the motor control unit container 410. The motor control unit container 410 of the vehicle-mounted power supply apparatus is configured to accommodate a plurality of electrical components of the vehicle-mounted power supply apparatus 200. The electrical components refer to components such as a capacitor and an inductor or a combination of components, and are located in the vehicle-mounted power supply apparatus 200 for power supply conversion.

In an embodiment, with reference to FIG. 8, the power module 220 further includes a horizontal insulation plate 231 extending in a length direction of the liquid cooling radiator 210.

In this embodiment of this application, a side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The power module 220 includes a horizontal insulation plate 231 extending in an X reverse direction. In the Y direction, the horizontal insulation plate 231 separately extends in directions of the two electrical connectors 222. In the Z positive direction, the horizontal insulation plate 231 and the liquid cooling radiator 210 are located on a same side of the packaging housing 221. The horizontal insulation plate 231 is attached to the packaging housing 221. This avoids creepage between the two adjacent copper bar connectors 222a along a surface of the packaging housing 221, and increases a creepage distance between the two adjacent copper bar connectors 222a, to avoid a short circuit between the two adjacent copper bar connectors 222a, so as to avoid a short circuit of the power module 220.

In an embodiment, the horizontal insulation plate 231 and the packaging housing 221 are independent structures that can be separated from each other, and the horizontal insulation plate 231 may be fastened to the packaging housing 221 by using an adhesive, a fastener, a screw, or the like, so that the horizontal insulation plate 231 is attached to the packaging housing 221.

In this embodiment of this application, with reference to FIG. 8, a side of the power module in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b. There are two horizontal insulation plates 231. The power module 220 includes the horizontal insulation plate 231 extending in the X positive direction. In the Z positive direction, the horizontal insulation plate 231 and the liquid cooling radiator 210 are located on a same side of the packaging housing 221. The horizontal insulation plate 231 is attached to the packaging housing 221. This avoids creepage between two adjacent electrical connectors 222 along a surface of the packaging housing 221, and increases a creepage distance between the two adjacent electrical connectors 222, to avoid a short circuit between the two adjacent electrical connectors 222, so as to avoid a short circuit of the power module 220.

In an embodiment, with reference to FIG. 9, in the arrangement direction of the at least two electrical connectors 222, a sum of lengths of two adjacent electrical connectors 222 and a length of a gap between the two adjacent electrical connectors 222 is less than or equal to a length of the horizontal insulation plate 231, and the length of the horizontal insulation plate 231 is less than a length of the packaging housing 221.

In this embodiment of this application, with reference to FIG. 9, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. A sum of lengths of the two adjacent copper bar connectors 222a and a length of a gap between the adjacent copper bar connectors 222a is less than or equal to a length of the horizontal insulation plate 231. In this way, the horizontal insulation plate 231 can fully protect the packaging housing 221 and the copper bar connectors 222a, to avoid creepage between the two adjacent copper bar connectors 222a along a surface of the packaging housing 221, and increase a creepage distance between the two adjacent copper bar connectors 222a, so as to avoid a short circuit of the power module 220. In the Y direction, the length of the horizontal insulation plate 231 is less than a length of the packaging housing 221. The length of the horizontal insulation plate 231 is not beyond the length of the packaging housing 221, to avoid interference in mounting of another electrical component.

In this embodiment of this application, with reference to FIG. 9, the side of the power module in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b. In the Y direction, a horizontal insulation plate 231 extends in a direction of the copper bar connector 222a, and a length of the copper bar connector 222a is less than or equal to a length of the horizontal insulation plate 231. In this way, the horizontal insulation plate 231 can fully protect the packaging housing 221 and the copper bar connector 222a, to avoid creepage, along a surface of the packaging housing 221, between the plurality of pins 222b and the copper bar connector 222a that are adjacent, and increase a creepage distance between two adjacent electrical connectors 222, so as to avoid a short circuit of the power module 220. In the Y direction, the length of the horizontal insulation plate 231 is less than a length of the packaging housing 221. The length of the horizontal insulation plate 231 is not beyond the length of the packaging housing 221, to avoid interference in mounting of another electrical component.

In an embodiment, still with reference to FIG. 9, the horizontal insulation plate 231 includes a protruding strip 2311, and the protruding strip 2311 extends in the Y direction. In the Y direction, a length of the protruding strip 2311 is less than or equal to the length of the horizontal insulation plate 231, and in the X direction, a length of the protruding strip 2311 is less than a length of the horizontal insulation plate 231. The protruding strip is configured to fit with another electrical component or another fastened plate, to increase an insulation distance between the horizontal insulation plate 231 and another electrical component.

In an embodiment, the horizontal insulation plate 231 extends for a specific length in the X reverse direction, and in the X direction, a sum of the extended length of the horizontal insulation plate 231 and a length of the liquid cooling radiator 210 is less than or equal to a length of the power module 220, to save mounting space.

In an embodiment, with reference to FIG. 10, in an arrangement direction of the electrical connector 222 and the packaging housing 221, the vertical insulation plate 230 includes another horizontal insulation plate 232. The another horizontal insulation plate 232 is configured to be located on two sides of the packaging housing 221 with the horizontal insulation plate 231 in the thickness direction of the liquid cooling radiator 210, and is configured to be attached to the packaging housing 221.

In this embodiment of this application, the side of the power module in the X positive direction is an alternating-current power terminal side, and the alternating-current power terminal side of the power module includes two electrical connectors 222. Both the two electrical connectors 222 are copper bar connectors 222a, including one positive copper bar connector and one negative copper bar connector. The vertical insulation plate 230 includes another horizontal insulation plate 232 extending in the X reverse direction. In the Y direction, the horizontal insulation plate 231 separately extends in directions of the two electrical connectors 222. The another horizontal insulation plate 232 is configured to be located on two sides of the packaging housing 221 with the horizontal insulation plate 231 in the thickness direction of the liquid cooling radiator 210. The another horizontal insulation plate 232 is attached to the packaging housing 221, and is attached to the packaging housing 221 with the horizontal insulation plate 231. This ensures stability of the horizontal insulation plate 231 and the another horizontal insulation plate 232 on the vehicle-mounted power supply apparatus 200 during working.

In an embodiment, the another horizontal insulation plate 232 extends for a specific length in the X reverse direction, and in the X direction, the extended length of the another horizontal insulation plate 232 is equal to the extended length of the horizontal insulation plate 231.

In this embodiment of this application, with reference to FIG. 10, the side of the power module in the X reverse direction is a direct-current power terminal side, and the direct-current power terminal side of the power module 220 includes three electrical connectors 222. The three electrical connectors 222 include one copper bar connector 222a and a plurality of pins 222b, and the copper bar connector 222a is located between the plurality of pins 222b. Another horizontal insulation plate 232 extends in the X positive direction. The another horizontal insulation plate 232 is configured to be located on two sides of the packaging housing 221 with the horizontal insulation plate 231 in the thickness direction of the liquid cooling radiator 210. The another horizontal insulation plate 232 is attached to the packaging housing 221, and is attached to the packaging housing 221 with the horizontal insulation plate 231. This ensures stability of the horizontal insulation plate 231 and the another horizontal insulation plate 232 on the vehicle-mounted power supply apparatus 200 during working.

In an embodiment, with reference to FIG. 10, a sum of lengths of two adjacent electrical connectors 222 and a length of a gap between the two adjacent electrical connectors 222 is less than or equal to a length of the another horizontal insulation plate 232. In the Y direction, the length of the another horizontal insulation plate 232 is less than the length of the packaging housing 221, and the length of the another horizontal insulation plate 232 is equal to the length of the horizontal insulation plate 231. In an embodiment, in the Y direction, the length of the another horizontal insulation plate is less than the length of the horizontal insulation plate 231. In an embodiment, in the Y direction, the length of the another horizontal insulation plate is greater than the length of the horizontal insulation plate 231.

In an embodiment, still with reference to FIG. 10, the horizontal insulation plate 231 and the another horizontal insulation plate 232 are disposed opposite to each other in the Z direction. Specifically, the horizontal insulation plate 231 and the another horizontal insulation plate 232 are respectively attached to two sides of the packaging housing 221 in the Z direction. Disposing the another horizontal insulation plate 232 can increase an area for protecting the packaging housing 221. The horizontal insulation plate 231 and the another horizontal insulation plate 232 can clamp the packaging housing 221, to prevent the horizontal insulation plate 231 and the another horizontal insulation plate 232 from detaching during working of the vehicle-mounted power supply apparatus 200, so as to ensure stability of the horizontal insulation plate 231 and the another horizontal insulation plate 232 on the vehicle-mounted power supply apparatus 200 during working. This better protects the power module 220, and avoids a short circuit of the power module 220.

In an embodiment, with reference to FIG. 11, the vehicle-mounted power supply apparatus 200 includes a connection plate 240, and the connection plate 240 is configured to connect to the horizontal insulation plate 231 and the another horizontal insulation plate 232 in the thickness direction of the liquid cooling radiator 210.

In this embodiment of this application, still with reference to FIG. 11, the vehicle-mounted power supply apparatus 200 includes a connection plate 240, and the connection plate 240 extends in the Z direction and is attached to a plane. In the X positive direction, an end surface of the horizontal insulation plate 231 and an end surface of the another horizontal insulation plate 232 are located on a same side of the plane of the packaging housing 221. The connection plate 240 is connected to the horizontal insulation plate 231 and the another horizontal insulation plate 232 in the Z direction, to fasten the horizontal insulation plate 231 and the another horizontal insulation plate 232.

In an embodiment, the connection plate 240 has a specific width in the X positive direction. In the Z direction, a length of the connection plate 240 is equal to a sum of lengths of the horizontal insulation plate 231, the another horizontal insulation plate 232, and the packaging housing 221. The length of the connection plate 240 is not beyond the lengths of the horizontal insulation plate 231 and the another horizontal insulation plate 232, to avoid interference in mounting of another electrical component.

In an embodiment, the horizontal insulation plate 231, the another horizontal insulation plate 232, and the connection plate 240 jointly enclose an accommodation part, and an opening of the accommodation part faces a side wall of the packaging housing 221 in the X direction, so that the accommodation part clamps the two sides of the packaging housing 221 in the Z direction. This enhances stability of connection between the connection plate 240 and a plurality of electrical connectors 222, increases a creepage distance between two adjacent electrical connectors 222 along a surface of the packaging housing 221, and improves effect of protecting the packaging housing 221.

In an embodiment, the connection plate 240 is fastened to the horizontal insulation plate 231 and the another horizontal insulation plate 232, and the connection plate 240 may be fastened to the horizontal insulation plate 231 and the another horizontal insulation plate 232 by using an adhesive, a fastener, a bolt, or the like. Alternatively, the connection plate 240, the horizontal insulation plate 231, and the another horizontal insulation plate 232 are an integrated structure, are formed through integrated injection molding, and have high connection strength.

In an embodiment, with reference to FIG. 12, the connection plate 240 includes a through hole 241, and the through hole 241 is configured to: run through the connection plate 240 in an arrangement direction of the electrical connector 222 and the packaging housing 221, and accommodate the electrical connector 222.

In this embodiment of this application, with reference to FIG. 12, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. A through hole 241 is provided on a connection plate in the X direction, and the through hole 241 runs through the connection plate 240 in the X direction. The through hole 241 is strip-shaped, and is configured to accommodate a copper bar connector 222a. The copper bar connector 222a is configured to pass through the through hole 241. In the Y direction, a length of the through hole 241 is equal to a length of the copper bar connector 222a. In the Z direction, a length of the through hole 241 is equal to a length of the copper bar connector 222a. In the Y direction, two sides of the copper bar connector 222a are attached to two sides of an inner wall of the through hole 241, and in the Z direction, two sides of the copper bar connector 222a abut against two sides of an inner wall of the through hole 241, to enhance stability of connection between the copper bar connector 222a and the through hole 241, and prevent the copper bar connector 222a from sliding. In an embodiment, in the Y direction, the length of the through hole 241 is greater than the length of the copper bar connector 222a, in the Z direction, the length of the through hole 241 is greater than the length of the copper bar connector 222a, and the through hole 241 is configured to accommodate the copper bar connector 222a.

In an embodiment, still with reference to FIG. 13, the vehicle-mounted power supply apparatus 200 includes at least three electrical connectors 222, and there may be three or four electrical connectors 222 or the like. The at least three electrical connectors 222 are located on a same side of the packaging housing 221 in a direction perpendicular to the thickness of the liquid cooling radiator 210.

In this embodiment of this application, still with reference to FIG. 12, the side of the power module 220 in the X reverse direction is a direct-current power terminal side configured to convert a direct current into a direct current for output, and the direct-current power terminal side of the power module 220 includes three electrical connectors 222. One electrical connector 222 is a copper bar connector 222a, the other two electrical connectors 222 are a plurality of pins 222b, and the copper bar connector 222a is located between the plurality of pins 222b in the Y direction.

FIG. 18 is another diagram of a vehicle-mounted power supply apparatus according to an embodiment of this application.

In an embodiment, with reference to FIG. 18, there are at least two power modules 220, and there may be two, three, or four power modules 220 or the like. The power modules 220 are sequentially arranged in the Y direction, and two adjacent power modules 220 are fastened by using a bolt or the like, to ensure stability of the power modules 220.

In an embodiment, with reference to FIG. 18, there are two liquid cooling radiators 210, one liquid cooling radiator 210 is located on a side of the power module 220 in the Z positive direction, the other liquid cooling radiator 210 is located on a side of the power module 220 in a Z reverse direction, the two liquid cooling radiators 210 are sandwiched between the power modules 220, a water path is disposed in each of the two liquid cooling radiators 210, and water paths in the two liquid cooling radiators 210 are in a connected state and are configured to dissipate heat from the power modules 220, to improve cooling effect and achieve better heat dissipation efficiency.

FIG. 19 is another diagram of a vehicle-mounted power supply apparatus according to an embodiment of this application.

In an embodiment, with reference to FIG. 19, the vehicle-mounted power supply apparatus 200 includes a water absorption layer 270, the liquid cooling radiator 210 is configured to be fastened to the water absorption layer 270, and the water absorption layer 270, the liquid cooling radiator 210, and the power module 220 are sequentially arranged in the thickness direction of the liquid cooling radiator 210.

In this embodiment of this application, with reference to FIG. 19, the vehicle-mounted power supply apparatus 200 includes the water absorption layer 270, and the water absorption layer 270, the liquid cooling radiator 210, and the power module 220 are sequentially arranged in the Z direction. In the X direction, a length of the water absorption layer 270 is less than the length of the liquid cooling radiator 210, and in the Y direction, a length of the water absorption layer 270 is less than the length of the liquid cooling radiator 210. The liquid cooling radiator 210 is configured to be fastened to the water absorption layer 270, to enhance stability of the water absorption layer 270.

In an embodiment, the water absorption layer 270 may be fastened to the liquid cooling radiator 210 by using an adhesive, to fasten the water absorption layer 270 to the liquid cooling radiator 210, so that the water absorption layer 270 is attached to the liquid cooling radiator 210.

In an embodiment, a material of the water absorption layer 270 includes a water absorption material such as porous foam or sponge, to absorb condensate water generated by the liquid cooling radiator 210 in a process of cooling the power module 220, so as to avoid a short circuit of the power module 220 caused by flowing of the condensate water generated by the liquid cooling radiator 210 to the power module 220.

In an embodiment, there are two liquid cooling radiators 210, and there are two water absorption layers 270. One water absorption layer 270 is disposed on a side that is of each liquid cooling radiator 210 and that faces away from the power module 220 in the Z direction, to absorb condensate water generated by the liquid cooling radiator 210 in a process of cooling the power module 220.

An embodiment of this application provides a powertrain. Refer to FIG. 1 and FIG. 2. The powertrain 10 includes a drive motor 100, a vehicle-mounted power supply apparatus 200, and a reducer 300. In an embodiment, the reducer 300 includes a single-speed reducer, a two-speed reducer, or a transmission. In an embodiment, the reducer 300 includes an input shaft 310, an intermediate shaft 320, and an output shaft 330. As shown in FIG. 2, the reducer 300 includes the input shaft 310, the intermediate shaft 320, and the output shaft 330. The input shaft 310 is configured to be in transmission connection to the drive motor 100 and the intermediate shaft 320, the intermediate shaft 320 is configured to be in transmission connection to the output shaft 330, and the output shaft 330 is configured to be in transmission connection to a wheel 40. In an embodiment, the reducer 300 is in transmission connection to two wheels 40 through two half shafts 50 respectively. In an embodiment, the vehicle-mounted power supply apparatus 200 is configured to: receive an alternating current, and convert the alternating current into a direct current to charge a power battery 30. In an embodiment, the vehicle-mounted power supply apparatus 200 is configured to: receive a high-voltage direct current, and supply the direct current to the power battery 30 for charging. In an embodiment, the vehicle-mounted power supply apparatus includes a vehicle-mounted charger, a motor control unit, a direct current-direct current converter, or another vehicle-mounted power supply apparatus.

In an embodiment, the vehicle-mounted power supply apparatus 200 is configured to: receive a direct current of the power battery 30, convert the direct current into an alternating current, and transmit the alternating current to the drive motor 100. The drive motor 100 converts electric energy into mechanical energy. The drive motor 100 is configured to be in transmission connection to the reducer 300. The drive motor 100 drives, through the reducer 300, a wheel 40 of an electric vehicle 1 to rotate. In an embodiment, the vehicle-mounted charger converts an alternating current of a power grid into a direct current, and transmits the direct current to the power battery 30 for charging. In an embodiment, the vehicle-mounted charger includes a direct current converter module. The direct current converter module converts a high-voltage direct current into a low-voltage direct current, to supply power to a low-voltage electrical system such as a light, a dashboard, or an air conditioner in the electric vehicle 1.

FIG. 3 is an assembly diagram of a powertrain according to an embodiment of this application. FIG. 4 is a diagram of the inside of a motor control unit container of a powertrain according to an embodiment of this application.

In an embodiment, with reference to FIG. 3 and FIG. 4, a housing 400 of the powertrain 10 includes a motor control unit container 410, a motor container 420, and a reducer container 430. This application provides a vehicle-mounted power supply apparatus. In embodiments of this application, a motor control unit is used as an example of the vehicle-mounted power supply apparatus 200. The motor control unit is merely an embodiment for description. During actual application, the vehicle-mounted power supply apparatus is not limited to the motor control unit. Other similar structures, for example, other vehicle-mounted power supply apparatuses including a liquid cooling radiator and a power module and having a vertical insulation plate, fall within the protection scope of this application. The vehicle-mounted power supply apparatus 200 is a part of the powertrain 10, and is integrated into the housing 400 of the powertrain 10. The motor control unit container 410 of the powertrain is configured to accommodate a plurality of electrical components of the motor control unit, including a component such as a capacitor or an inductor or a combination of components. The electrical component is configured to perform power supply conversion in the motor control unit. The motor container 420 and the reducer container 430 of the powertrain are distributed on two axial sides of the housing 400 of the powertrain. The motor container 420 is configured to accommodate the drive motor of the powertrain 10. An axis of the drive motor is parallel to an axis of the motor container 420. An orientation of an opening of the motor container 420 is opposite to an orientation of an opening of the reducer container 430 in an axial direction of the housing 400. The housing 400 of the powertrain includes a motor end cover and a reducer end cover, the motor end cover is configured to enclose the motor container 420, and the reducer end cover is configured to enclose the reducer container 430. The motor control unit container 410 is located on a radial side of the motor container 420, and an inner wall of the motor control unit container 410 may be a part of an outer wall surface of the motor container 420, to form an accommodation cavity with large capacity, so as to meet a mounting requirement of the vehicle-mounted power supply apparatus 200. In an embodiment, the housing 400 of the powertrain 10 and a housing of the vehicle-mounted power supply apparatus 200 are an integrated structure. In other words, the housing of the vehicle-mounted power supply apparatus 200 is the housing 400 of the powertrain 10. The housing 400 includes the motor control unit container 410. The motor control unit container 410 of the vehicle-mounted power supply apparatus is configured to accommodate a plurality of electrical components of the vehicle-mounted power supply apparatus 200. The electrical components refer to components such as a capacitor and an inductor or a combination of components, and are located in the vehicle-mounted power supply apparatus 200 for power supply conversion.

FIG. 5 is an exploded view of a vehicle-mounted power supply apparatus according to an embodiment of this application. FIG. 6 is another diagram of a vehicle-mounted power supply apparatus according to an embodiment of this application. FIG. 7 is a diagram of a relationship between a power module and a vertical insulation plate according to an embodiment of this application.

In an embodiment, with reference to FIG. 5, the vehicle-mounted power supply apparatus 200 includes a circuit board 201, a liquid cooling radiator 210, a power module 220, and a housing 202 of the vehicle-mounted power supply apparatus. The circuit board 201, the liquid cooling radiator 210, and the power module 220 are jointly integrated into the housing 202 of the vehicle-mounted power supply apparatus, to help optimize utilization of space of the vehicle-mounted power supply apparatus 200. The circuit board 201, the liquid cooling radiator 210, and the power module 220 are stacked in a thickness direction of the liquid cooling radiator 210, to achieve an efficient heat dissipation path. The circuit board 201 is configured to control operation of the power module 220. The liquid cooling radiator 210 is configured to dissipate heat from the circuit board 201 and the power module 220, to ensure normal working of the circuit board 201 and the power module 220. There may be one, two, or three liquid cooling radiators 210 or the like. Disposing a plurality of liquid cooling radiators 210 helps improve effect of dissipating heat from the power module 220 by the liquid cooling radiator 210. In an embodiment, the liquid cooling radiator 210 may be a single-layer heat dissipation plate structure. In an embodiment, the liquid cooling radiator 210 may be a double-layer heat dissipation plate structure, and the double-layer heat dissipation plate is symmetrically disposed on two sides of the power module 220. This helps improve effect of dissipating heat from the power module 220 by the heat dissipation plate, and temperature is even.

In an embodiment, with reference to FIG. 6 and FIG. 7, the vehicle-mounted power supply apparatus 200 includes the liquid cooling radiator 210 and the power module 220. The liquid cooling radiator 210 and the power module 220 are configured to be stacked in the thickness direction of the liquid cooling radiator 210, to achieve an efficient heat dissipation path. The thickness direction of the liquid cooling radiator 210 and a direction perpendicular to an axial direction of the motor control unit container 410 are a Z direction. The liquid cooling radiator 210 is located on a side of the power module 220 in a Z positive direction. In an embodiment, the power module 220 includes an insulated gate bipolar transistor (Insulated Gate Bipolar Transistor, IGBT) module, a silicon carbide power module, or the like, and is applicable to a high-voltage and high-power scenario of a new energy vehicle or the like.

In embodiments of this application, an IGBT module is used as an example of the power module. The IGBT module is merely an embodiment for description. During actual application, the power module is not limited to the IGBT module. Other similar power modules fall within the protection scope of this application. In an embodiment, the power module 220 includes a packaging housing 221 and at least two electrical connectors 222. The packaging housing 221 is configured to protect an internal structure of the power module 220, and has insulation and heat conduction functions. The at least two electrical connectors 222 are located on a same side of the packaging housing 221 in a direction perpendicular to a thickness of the liquid cooling radiator 210. A direction in which the packaging housing 221 faces the electrical connectors 222 is an X positive direction. The at least two electrical connectors 222 are located at two ends of an X direction. An arrangement direction of the at least two electrical connectors 222 is a Y direction. In an embodiment, a side of the packaging housing 221 in the X direction is an alternating-current power terminal side, configured to convert an alternating current into a direct current for output, and another side of the packaging housing 221 in the X direction is a direct-current power terminal side, configured to convert a direct current into a direct current for output. In an embodiment, the electrical connector 222 includes a copper bar connector, a pin, or the like, and the electrical connector 222 is configured to electrically connect to the packaging housing 221.

In an embodiment, the housing 400 of the powertrain 10 and a housing of the vehicle-mounted power supply apparatus 200 are an integrated structure. In other words, the housing of the vehicle-mounted power supply apparatus 200 is the housing 400 of the powertrain 10. The housing 400 includes the motor control unit container 410. The motor control unit container 410 of the vehicle-mounted power supply apparatus is configured to accommodate a plurality of electrical components of the vehicle-mounted power supply apparatus 200. The electrical components refer to components such as a capacitor and an inductor or a combination of components, and are located in the vehicle-mounted power supply apparatus 200 for power supply conversion.

In an embodiment, the liquid cooling radiator 210 includes a water path plate, the liquid cooling radiator 210 includes a water path, the water path in the liquid cooling radiator 210 is used for a coolant to flow, and the coolant in the water path is configured to dissipate heat from the power module 220. In an embodiment, the liquid cooling radiator 210 may be fastened to the power module 220 by using a fastener, a screw, or the like, so that the liquid cooling radiator 210 is attached to the power module 220, to improve efficiency of dissipating heat from the power module 220 by the liquid cooling radiator 210.

FIG. 19 is another diagram of a vehicle-mounted power supply apparatus according to an embodiment of this application.

In an embodiment, with reference to FIG. 19, the vehicle-mounted power supply apparatus 200 includes a water absorption layer 270, the liquid cooling radiator 210 is configured to be fastened to the water absorption layer 270, and the water absorption layer 270, the liquid cooling radiator 210, and the power module 220 are sequentially arranged in the thickness direction of the liquid cooling radiator 210.

In this embodiment of this application, with reference to FIG. 19, the vehicle-mounted power supply apparatus 200 includes the water absorption layer 270, and the water absorption layer 270, the liquid cooling radiator 210, and the power module 220 are sequentially arranged in the Z direction. In the X direction, a length of the water absorption layer 270 is less than the length of the liquid cooling radiator 210, and in the Y direction, a length of the water absorption layer 270 is less than the length of the liquid cooling radiator 210. The liquid cooling radiator 210 is configured to be fastened to the water absorption layer 270, to enhance stability of the water absorption layer 270.

In an embodiment, the water absorption layer 270 may be fastened to the liquid cooling radiator 210 by using an adhesive, to fasten the water absorption layer 270 to the liquid cooling radiator 210, so that the water absorption layer 270 is attached to the liquid cooling radiator 210.

In an embodiment, a material of the water absorption layer 270 includes a water absorption material such as porous foam or sponge, to absorb condensate water generated by the liquid cooling radiator 210 in a process of cooling the power module 220, so as to avoid a short circuit of the power module 220 caused by flowing of the condensate water generated by the liquid cooling radiator 210 to the power module 220.

In an embodiment, there is one liquid cooling radiator 210, and there are two water absorption layers 270. In the Z direction, one water absorption layer 270 is disposed on a side that is of the liquid cooling radiator 210 and that faces the power module 220, and one water absorption layer 270 is disposed on a side that is of the liquid cooling radiator 210 and that faces away from the power module 220, to absorb condensate water generated by the liquid cooling radiator 210 in a process of cooling the power module 220.

In an embodiment, there are two liquid cooling radiators 210, and there are two water absorption layers 270. One water absorption layer 270 is disposed on a side that is of each liquid cooling radiator 210 and that faces away from the power module 220 in the Z direction, to absorb condensate water generated by the liquid cooling radiator 210 in a process of cooling the power module 220.

In an embodiment, with reference to FIG. 11, the vehicle-mounted power supply apparatus 200 includes a connection plate 240, and the connection plate 240 is configured to be attached to the packaging housing 221 of the vehicle-mounted power supply apparatus 200 in the thickness direction of the liquid cooling radiator 210.

In this embodiment of this application, still with reference to FIG. 11, the vehicle-mounted power supply apparatus 200 includes a connection plate 240, and the connection plate 240 extends in the Z direction and is attached to the vehicle-mounted power supply apparatus 200. In an embodiment, the connection plate 240 has a specific width in the X positive direction. In the Z direction, a length of the connection plate 240 is equal to a thickness of the packaging housing 221 of the vehicle-mounted power supply apparatus 200. In the X direction, the length of the connection plate 240 is not beyond a length of the packaging housing 221, to avoid interference in mounting of another electrical component.

In an embodiment, the connection plate 240 may be fastened to the packaging housing 221 by using an adhesive, a fastener, a bolt, or the like, to have high connection strength.

In an embodiment, with reference to FIG. 12, the connection plate 240 includes a through hole 241, and the through hole 241 is configured to: run through the connection plate 240 in an arrangement direction of the electrical connector 222 and the packaging housing 221, and accommodate the electrical connector 222.

In this embodiment of this application, with reference to FIG. 12, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. A through hole 241 is provided on a connection plate in the X direction, and the through hole 241 runs through the connection plate 240 in the X direction. The through hole 241 is strip-shaped, and is configured to accommodate a copper bar connector 222a. The copper bar connector 222a is configured to pass through the through hole 241. In the Y direction, a length of the through hole 241 is equal to a length of the copper bar connector 222a. In the Z direction, a length of the through hole 241 is equal to a length of the copper bar connector 222a. In the Y direction, two sides of the copper bar connector 222a are attached to two sides of an inner wall of the through hole 241, and in the Z direction, two sides of the copper bar connector 222a abut against two sides of an inner wall of the through hole 241, to enhance stability of connection between the copper bar connector 222a and the through hole 241, and prevent the copper bar connector 222a from sliding. In an embodiment, in the Y direction, the length of the through hole 241 is greater than the length of the copper bar connector 222a, in the Z direction, the length of the through hole 241 is greater than the length of the copper bar connector 222a, and the through hole 241 is configured to accommodate the copper bar connector 222a.

In an embodiment, still with reference to FIG. 12, the vehicle-mounted power supply apparatus 200 includes at least three electrical connectors 222, and there may be three or four electrical connectors 222 or the like. The at least three electrical connectors 222 are located on a same side of the packaging housing 221 in a direction perpendicular to the thickness of the liquid cooling radiator 210.

In this embodiment of this application, still with reference to FIG. 12, the side of the power module 220 in the X reverse direction is a direct-current power terminal side configured to convert a direct current into a direct current for output, and the direct-current power terminal side of the power module 220 includes three electrical connectors 222. One electrical connector 222 is a copper bar connector 222a, the other two electrical connectors 222 are a plurality of pins 222b, and the copper bar connector 222a is located between the plurality of pins 222b in the Y direction.

In an embodiment, with reference to FIG. 13, the vehicle-mounted power supply apparatus 200 includes another connection plate 250, the connection plate 240 is configured to be fastened to the another connection plate 250, the another connection plate 250 is configured to be located on a same side of the electrical connector 222 as the liquid cooling radiator 210 in the thickness direction of the liquid cooling radiator 210, the another connection plate 250 includes another through hole 251, and the another through hole 251 is configured to run through the another connection plate 250 in the thickness direction of the liquid cooling radiator 210.

In this embodiment of this application, with reference to FIG. 13, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. The vehicle-mounted power supply apparatus 200 includes another connection plate 250. The another connection plate 250 and the liquid cooling radiator 210 are located on a same side of the electrical connector 222 in the Z direction. The connection plate 240 is fastened, and the connection plate 240 is perpendicular to the another connection plate 250. The another connection plate 250 and the electrical connector 222 are sequentially stacked in the Z direction, to separate the electrical connector 222 from another electrical component, so as to avoid interference of the another electrical component to the electrical connector 222.

In this embodiment of this application, with reference to FIG. 13, another through hole 251 is provided on the another connection plate 250 in the Z direction, and the another through hole 251 runs through the another connection plate 250 in the Z direction. The another through hole 251 is circular, or may be in another shape. The another through hole 251 is configured to run through the another connection plate 250 in the Z direction. The copper bar connector 222a includes a copper bar through hole 2221. The copper bar through hole 2221 is circular, or may be in another shape. The copper bar through hole 2221 is configured to run through the copper bar connector 222a in the Z direction. The copper bar through hole 2221 and the another through hole 251 are provided opposite to each other in the Z direction. In the X direction, an inner diameter of the copper bar through hole 2221 is less than an inner diameter of the another through hole 251. Each of the copper bar through hole 2221 and the another through hole 251 is configured to connect to another electrical component.

In an embodiment, the copper bar through hole 2221 and the another through hole 251 are provided opposite to each other in the Z direction. In the X direction, the inner diameter of the copper bar through hole 2221 is equal to the inner diameter of the another through hole 251. Each of the copper bar through hole 2221 and the another through hole 251 is configured to connect to another electrical component.

In an embodiment, with reference to FIG. 13, in the arrangement direction of the at least two electrical connectors 222, a length of the another connection plate 250 is greater than or equal to a length of at least one electrical connector 222.

In this embodiment of this application, with reference to FIG. 13, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. The another connection plate 250 and a copper bar connector 222a are disposed opposite to each other in the Z direction, and in the Y direction, a length of the another connection plate 250 is greater than a length of the copper bar connector 222a disposed corresponding to the another connection plate 250, so that the another connection plate 250 can fully bear the copper bar connector 222a. In an embodiment, the another connection plate 250 and the copper bar connector 222a are disposed opposite to each other in the Z direction, and in the Y direction, the length of the another connection plate 250 is equal to the length of the copper bar connector 222a disposed corresponding to the another connection plate 250.

In this embodiment of this application, still with reference to FIG. 13, in the Y direction, a side of the another connection plate 250 does not protrude from a side of the packaging housing 221 on the same side, to avoid interference in mounting of another electrical component.

In an embodiment, with reference to FIG. 13, there are at least two other connection plates 250, and there may be two, three, or four other connection plates 250 or the like. The at least two other connection plates 250 are sequentially arranged in the Y direction in the arrangement direction of the at least two electrical connectors 222.

In this embodiment of this application, with reference to FIG. 13, the side of the power module in the X positive direction is an alternating-current power terminal side, and the alternating-current power terminal side of the power module 220 includes two electrical connectors 222. Both the two electrical connectors 222 are copper bar connectors 222a, including one positive copper bar connector and one negative copper bar connector. The alternating-current power terminal side of the power module is used as an example. For example, there are two other connection plates 250. There are two other connection plates 250. In the Y direction, the two other connection plates 250 are sequentially arranged. In the Y direction, bottom walls of the two other connection plates 250 are located on a same horizontal plane.

In an embodiment, in the Y direction, a sum of lengths of the two other connection plates 250 is greater than a sum of lengths of the two adjacent copper bar connectors 222a and a length of a gap between the two adjacent copper bar connectors 222a, to protect each copper bar connector 222a. In the Y direction, the sum of the lengths of the two other connection plates 250 is less than the length of the packaging housing 221. The lengths of the other connection plates 250 are not beyond the length of the packaging housing 221, to avoid interference in mounting of another electrical component. In an embodiment, in the Y direction, the sum of the lengths of the two other connection plates 250 is equal to the sum of the lengths of the two adjacent copper bar connectors 222a and the length of the gap between the two adjacent copper bar connectors 222a. In an embodiment, in the Y direction, the sum of the lengths of the two other connection plates 250 is equal to the length of the packaging housing 221.

In an embodiment, there are two other through holes, the other through holes 251 with a same shape and size are respectively provided on the two other connection plates 250 in the Y direction, and the two other through holes 251 are distributed on the two sides of the vertical insulation plate 230. Each of the other through holes 251 is provided opposite to one of copper bar through holes 2221, and each of the other through holes 251 is configured to connect to another electrical component.

FIG. 18 is another diagram of a vehicle-mounted power supply apparatus according to an embodiment of this application.

In an embodiment, with reference to FIG. 18, there are at least two power modules 220, and there may be two, three, or four power modules 220 or the like. The power modules 220 are sequentially arranged in the Y direction, and two adjacent power modules 220 are fastened by using a bolt or the like, to ensure stability of the power modules 220.

In an embodiment, with reference to FIG. 18, there are two liquid cooling radiators 210, one liquid cooling radiator 210 is located on a side of the power module 220 in the Z positive direction, the other liquid cooling radiator 210 is located on a side of the power module 220 in a Z reverse direction, the two liquid cooling radiators 210 are sandwiched between the power modules 220, a water path is disposed in each of the two liquid cooling radiators 210, and water paths in the two liquid cooling radiators 210 are in a connected state and are configured to dissipate heat from the power modules 220, to improve cooling effect and achieve better heat dissipation efficiency.

The foregoing embodiments are merely intended to describe the technical solutions of this application, but not to limit this application. Although this application is described in detail with reference to the foregoing embodiments, a person of ordinary skill in the art should understand that modifications may still be made to the technical solutions described in the foregoing embodiments or equivalent replacements may still be made to some technical features thereof, without departing from the spirit and scope of the technical solutions of embodiments of this application, and these modifications and replacements shall fall within the protection scope of this application.

## Claims

1. A vehicle-mounted power supply apparatus used in an electric vehicle, wherein the vehicle-mounted power supply apparatus is configured to supply power to a load of the electric vehicle, the vehicle-mounted power supply apparatus comprises a liquid cooling radiator and a power module, the liquid cooling radiator and the power module are stacked in a thickness direction of the liquid cooling radiator, the power module comprises a packaging housing and a plurality of electrical connectors protruding from a surface of the packaging housing, and at least two of the plurality of electrical connectors are arranged on a same side of the packaging housing in a direction perpendicular to a thickness of the liquid cooling radiator; and
the vehicle-mounted power supply apparatus comprises a vertical insulation plate extending in the thickness direction of the liquid cooling radiator, and the vertical insulation plate is located between two electrical connectors on a same side of the packaging housing.

2. The vehicle-mounted power supply apparatus according to claim 1, wherein the power module further comprises a horizontal insulation plate, the horizontal insulation plate extends in a thickness direction of the vertical insulation plate, and the horizontal insulation plate protrudes from a surface of the packaging housing and is connected to the vertical insulation plate.

3. The vehicle-mounted power supply apparatus according to claim 2, wherein in an arrangement direction of the at least two electrical connectors, a sum of lengths of two adjacent electrical connectors and a length of a gap between the two adjacent electrical connectors is less than or equal to a length of the horizontal insulation plate, and the length of the horizontal insulation plate is less than a length of the packaging housing.

4. The vehicle-mounted power supply apparatus according to claim 2 or 3, wherein the power module further comprises another horizontal insulation plate, the another horizontal insulation plate extends in the thickness direction of the vertical insulation plate, and the another horizontal insulation plate is configured to: be located on two sides of the packaging housing with the horizontal insulation plate in the thickness direction of the liquid cooling radiator, protrude from another surface of the packaging housing, and connect to the vertical insulation plate.

5. The vehicle-mounted power supply apparatus according to claim 4, wherein the power module comprises a connection plate, the vertical insulation plate is configured to be fastened to the connection plate, and the connection plate is configured to connect to the horizontal insulation plate and the another horizontal insulation plate in the thickness direction of the liquid cooling radiator.

6. The vehicle-mounted power supply apparatus according to claim 5, wherein the connection plate comprises a through hole, and the through hole is configured to: run through the connection plate in an arrangement direction of the electrical connector and the packaging housing, and accommodate the electrical connector.

7. The vehicle-mounted power supply apparatus according to claim 1, wherein the power module comprises another connection plate, the vertical insulation plate is configured to be fastened to the another connection plate, the another connection plate is configured to be located on a same side of the electrical connector as the liquid cooling radiator in the thickness direction of the liquid cooling radiator, the another connection plate comprises another through hole, and the another through hole is configured to run through the another connection plate in the thickness direction of the liquid cooling radiator.

8. The vehicle-mounted power supply apparatus according to claim 7, wherein in an arrangement direction of the at least two electrical connectors, a length of the another connection plate is greater than or equal to a length of at least one electrical connector, and a length of the another connection plate on a side of the vertical insulation plate is less than or equal to a length of the packaging housing on the same side of the vertical insulation plate.

9. The vehicle-mounted power supply apparatus according to claim 7 or 8, wherein there are at least two other connection plates, and the at least two connection plates are located on two sides of the vertical insulation plate in the arrangement direction of the at least two electrical connectors.

10. The vehicle-mounted power supply apparatus according to any one of claims 7 to 9, wherein the vehicle-mounted power supply apparatus comprises a fastened plate, the fastened plate, the liquid cooling radiator, and the power module are sequentially arranged in the thickness direction of the liquid cooling radiator, the fastened plate comprises a third through hole, an outer wall surface on a side that is of the another connection plate and that faces the fastened plate comprises a protrusion, and the protrusion is configured to pass through the third through hole in the thickness direction of the liquid cooling radiator.

11. The vehicle-mounted power supply apparatus according to any one of claims 1 to 10, wherein at least three of the plurality of electrical connectors are arranged on a same side of the packaging housing, and at least one vertical insulation plate is comprised between any two adjacent electrical connectors in an arrangement direction of the at least three electrical connectors.

12. The vehicle-mounted power supply apparatus according to any one of claims 1 to 11, wherein a side edge on a side of the packaging housing comprises a recess, the recess is configured to accommodate a side edge on a side of the vertical insulation plate, in the arrangement direction of the at least two electrical connectors, a length of the recess is equal to a length of the vertical insulation plate, and in the arrangement direction of the electrical connector and the packaging housing, the side edge on the side of the vertical insulation plate is configured to be attached to a bottom wall of the recess.

13. The vehicle-mounted power supply apparatus according to any one of claims 1 to 12, wherein the vehicle-mounted power supply apparatus comprises a water absorption layer, the liquid cooling radiator is configured to be fastened to the water absorption layer, and the water absorption layer, the liquid cooling radiator, and the power module are sequentially arranged in the thickness direction of the liquid cooling radiator.

14. A powertrain, wherein the powertrain comprises a motor and the vehicle-mounted power supply apparatus according to any one of claims 1 to 13, and the vehicle-mounted power supply apparatus is configured to connect to the motor.

15. An electric vehicle, wherein the electric vehicle comprises a plurality of wheels and the powertrain according to claim 14, and the powertrain is configured to drive one or more of the wheels.
